# EUROPEAN PATENT SPECIFICATION

(11) **EP 1 810 555 B1**
(45) Date of publication and mention of the grant of the patent: **16.08.2017**
(21) Application number: 05825576.1
(22) Date of filing: 09.11.2005
(51) Int. Cl.: H05K 5/02, G08B 25/00, H05K 5/00

(54) **REMOTE MONITOR IN ELECTRIC HOME APPLIANCES**
FERNÜBERWACHUNGSGERÄT ELEKTRISCHER HEIMGERÄTE
TELESURVEILLANCE D'APPAREILS ELECTRIQUES DOMESTIQUES

(30) Priority: 10.11.2004 KR 20040091351; 10.11.2004 KR 20040091354; 10.11.2004 KR 20040091352; 15.11.2004 KR 20040092936
(43) Date of publication of application: 25.07.2007
(73) Proprietor: LG Electronics Inc., Seoul 07336 (KR)
(72) Inventor: NO, Yang Hwan, Gyeongsangnam-do 641-752 (KR); CHO, Han Ki, Gyeongsangnam-do 641-200 (KR); JANG, Ho Sung, Gyeongsangnam-do 667-891 (KR)
(74) Representative: Ter Meer Steinmeister & Partner
(86) International application number: PCT/KR2005/003782
(87) International publication number: WO 2006/052079

(56) References cited:
- FR-A1- 2 762 660
- GB-A- 2 338 809
- US-A- 4 418 833
- US-A- 4 768 230
- US-A- 5 031 791
- US-A- 5 905 442
- US-A- 5 905 442
- US-A1- 2001 035 442
- US-A1- 2002 148 846
- US-A1- 2003 133 269
- US-A1- 2004 014 337

## Description

### [Technical Field]

The present invention relates to home appliances, and more particularly, to a remote monitor for remote, and easy monitoring and control of a state of a home appliance, such as a washing machine, or dryer far from a user.

### [Background Art]

US 4,768,230 discloses a remote monitor case with an upper and a lower case, with each case having a double circumference, wherein the circumferences have projections with different lengths. US 2003/0133269 A1 discloses an electronic digital controller with a load cell indicator with a housing having a double circumference. US 5,031,791 discloses an electronic enclosure case comprising first and second shells with mating abuttable rims, wherein the upper shell and the lower shell have a single circumference. US 2001/0035442 A1 discloses a casing for housing portable electronic equipment. The casing has a double circumference, with both inner circumference and upper circumference formed with the same length. GB 2 338 809 A is related to a remote supervisory control system.

US 2002/148846 A1, US 4,418,833, US 2004/0014337 A1; FR 2 762 660 A1 and JP 2005 317 692 A disclose case-assemblies using rim, groove and hook engaging in a respective hole in order to seal an interior of the case.

In general, the home appliance, an apparatus for operating by using electricity in a home, converts the electricity into a light, heat, or power, for convenience of a home life.

Recently, different from other home appliances, since a washing machine, or a dryer using electricity as power, not only occupies a large installation space, but also has big noise and vibration generated when the washing machine or dryer is operated, the washing machine, or a dryer is in general installed at a place, such as veranda, far from a living room.

Particularly, due to structures of most houses in the USA, and Europe, the washing machine is installed in a cellar, or separate warehouse, or the like, far from an actual living space.

Thus, the installation of the washing machine far from a living room where a user stays most of time causes difficulty in knowing progress of the washing machine, such as the present cycle of the washing machine or a time period left, easily.

That is, it is required for the user to go to the place where the washing machine is from time to time, for determining a state of progress of the washing machine every time, personally.

Moreover, after putting the washing machine into operation, if the user forgets a fact that the user put the washing machine into operation for a moment or completely, the laundry finished washing rumples, or has microbes increased thereon, to damage the laundry.

Furthermore, the user is liable to fail to notice an error in the cycle of the washing machine, to fail in taking a proper countermeasure, leaving the laundry in contact with detergent and the washing water for a long time to cause decoloring of the laundry, thereby damaging cloth of the laundry itself.

### [Disclosure]

### [Technical Problem]

The object of the present invention, designed for solving the problems of the related art, lies on providing a remote monitor for a home appliance, which enables easy and remote monitoring and control of a state of a home appliance, such as a washing machine, or dryer far from a user, for convenient and effective use of the home appliance. The objects are solved by the features of the independent claims.

### [Technical Solution]

To achieve the object of the present invention, a remote monitor for a home appliance, the remote monitor being connected to at least one home appliance with a predetermined communication system for displaying, and controlling of a state of the home appliance at a place far from the home appliance, includes a case forming an outside appearance of the remote monitor, including a lower case, and an upper case detachably mounted on an upper side of the lower case, the upper case having a window, and a control board in the case, the control board having various electronic components mounted thereon.

In another aspect of the present invention, a remote monitor for a home appliance, the remote monitor being connected to at least one home appliance with a predetermined communication system for displaying, and controlling of a state of the home appliance at a place far from the home appliance, including a case forming an outside appearance of the remote monitor, including a lower case, an upper case detachably mounted on an upper side of the lower case, the upper case having a window, and an outer case detachably mounted on an upper side of the upper case, the outer case having a display window in correspondence to the window, and a control board in the case, the control board having various electronic components mounted thereon.

In another aspect of the present invention, a remote monitor for a home appliance, the remote monitor being connected to at least one home appliance having a power line communication modem with a power line communication system for displaying, and controlling of a state of the home appliance at a place far from the home appliance, including a case forming an outside appearance of the remote monitor, including a lower case, a control board having a communication modem board on the lower case for transmission/reception of data to/from the modem at the home appliance through a power line, and a display board mounted on an upper side of the communication modem board securely, or detachably, for displaying a state of the home appliance to an outside, an upper case detachably mounted on an upper side of the lower case, the upper case having a window for exposing a display portion of the display board, a see-through sheet on an upper side of the upper case for enabling see-through, and a protective sheet on the see-through sheet having a see-through window corresponding to the window of the upper case.

In another aspect of the present invention, a remote monitor for a home appliance, the remote monitor being connected to at least one home appliance having a power line communication modem with a power line communication system for displaying, and controlling of a state of the home appliance at a place far from the home appliance, including a case forming an outside appearance of the remote monitor, including a lower case, a control board having a communication modem board on the lower case for transmission/reception of data to/from the modem at the home appliance through a power line, and a display board mounted on an upper side of the communication modem board securely, or detachably, for displaying a state of the home appliance to an outside, an upper case detachably mounted on an upper side of the lower case, the upper case having a window for exposing a display portion of the display board, an outer case detachably mounted on an upper side of the upper case having a display window corresponding to the window, a see-through sheet on an upper side of the outer case for enabling see-through, and a protective sheet on the see-through sheet having a see-through window corresponding to the display window of the outer case.

### [Advantageous Effects]

The remote monitor for a home appliance of the present invention has the following advantages.

First, user's easy and remote monitoring of a home appliance is permitted,

Second, the user can to take an appropriate measure at an appropriate time, thereby permitting effective maintenance and management of the home appliance,

Third, the user can make effective management of things, such as laundry, used for the home appliance.

### [Description of Drawings]

The accompanying drawings, which are included to provide a further understanding of the invention, serve to explain the principle of the invention together with the description. In the drawings;
FIG. 1 illustrates a diagram showing a state of use of a remote monitor in accordance with a preferred embodiment of the present invention, schematically;
FIG. 2 illustrates a perspective view of a remote monitor in accordance with a first preferred embodiment of the present invention;
FIG. 3 illustrates an exploded perspective view of the remote monitor in FIG. 2;
FIG. 4 illustrates a bottom perspective view of the outer case and the upper case in FIG. 3;
FIG. 5 illustrates a section across a line I-I in FIG. 2;
FIG. 6 illustrates a section across a line II-II in FIG. 2;
FIG. 7 illustrates an enlarged sectional view of "A" part in FIG. 5 in a state the upper case and the lower case are separated from each other;
FIG. 8 illustrates an enlarged sectional view of "B" part in FIG. 5 in a state the outer case and the upper case are separated from each other;
FIG. 9 illustrates a perspective view of a top side of an operation button;
FIG. 10 illustrates a perspective view of a bottom side of an operation button;
FIG. 11 illustrates a perspective view of a remote monitor in accordance with a first preferred embodiment of the present invention in a state the remote monitor is mounted on a hanger;
FIG. 12 illustrates a perspective view of a remote monitor in accordance with a second preferred embodiment of the present invention;
FIG. 13 illustrates an exploded perspective view of the remote monitor in FIG. 12;
FIG. 14 illustrates a bottom perspective view of the outer case and the upper case in FIG. 13;
FIG. 15 illustrates a section across a line III-III in FIG. 12;
FIG. 16 illustrates a section across a line IV-IV in FIG. 12;
FIG. 17 illustrates an enlarged sectional view of "C" part in FIG. 15 in a state the upper case and the lower case are separated from each other;
FIG. 18 illustrates an enlarged sectional view of "D" part in FIG. 15 in a state the outer case and the upper case are separated from each other;
FIG. 19 illustrates a perspective view of a top side of an operation button;
FIG. 20 illustrates a perspective view of a bottom side of an operation button; and
FIG. 21 illustrates a perspective view of a remote monitor in accordance with a second preferred embodiment of the present invention in a state the remote monitor is mounted on a hanger.

### [Best Mode]

Reference will now be made in detail to the preferred embodiments of the present invention, examples of which are illustrated in the accompanying drawings.

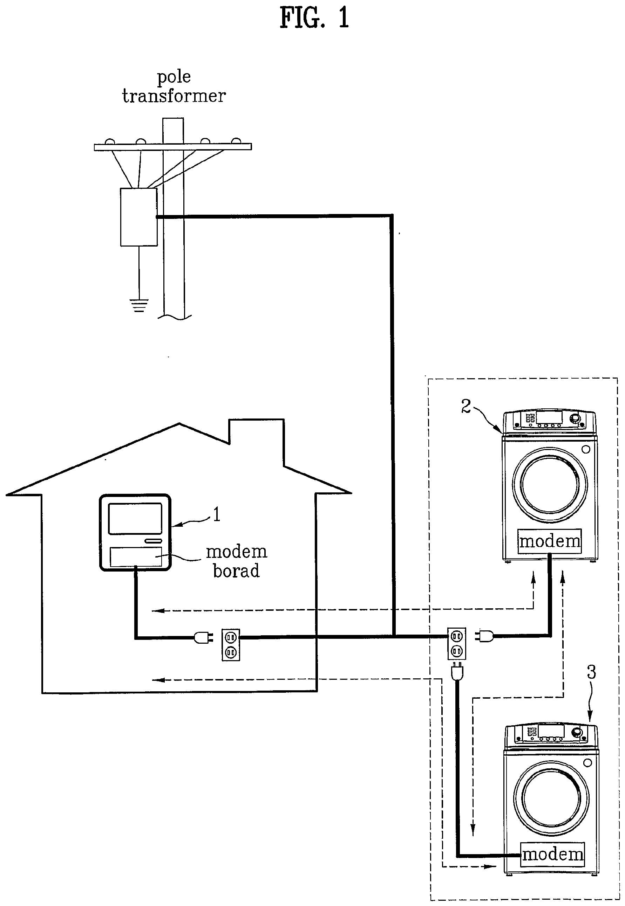

The remote monitor for a home appliance in accordance with a first preferred embodiment of the present invention will be described with reference to FIGS. 1 to 11.

Referring to FIG. 1, the remote monitor 1 is mounted at a place where a user stays much of time, such as a living room, or a bed room, or the like, while home appliances, such as a washing machine 2 and a dryer 3, are installed at space (a veranda, or a cellar) far from the living room, or the bed room.

The remote monitor 1 is connected to the home appliances, such as the washing machine 2 and the dryer 3, with a power line communication system.

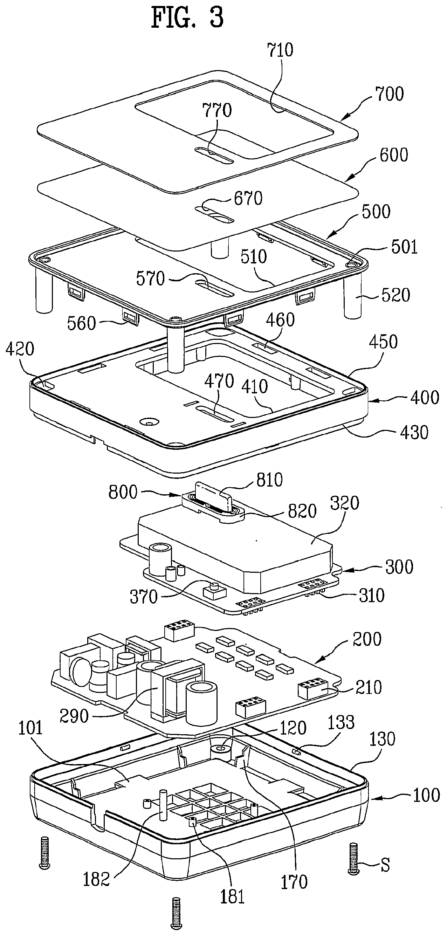

That is, the washing machine 2 and the dryer 3 have power line communication modems provided thereto respectively, and the remote monitor 1 has a board 200 (see FIG. 3) of a power line communication modem, for making data transmission/reception to/from the power line communication modems at the washing machine 2 and the dryer 3 through power line, respectively.

Accordingly, once the washing machine 2 and the dryer 3 are connected to the power line through a plug receptacle, and the remote monitor 1 is connected to the power line, the remote monitor 1 makes data transmission/reception to/from the washing machine 2 and the dryer 3 through the power line, and, not only displays progress of the washing machine 2 and the dryer 3 to an outside, but also controls the washing machine 2 and the dryer 3.

A structure of the remote monitor 1 will be described in more detail.

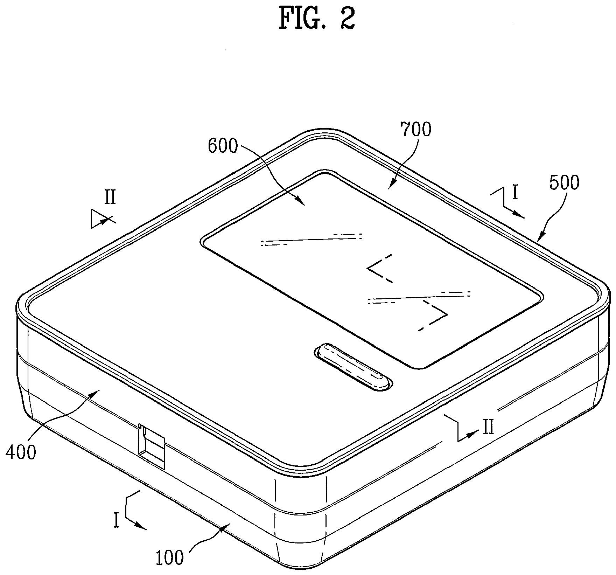

Referring to FIGS. 2 and 3, the remote monitor includes a lower case 100, a communication modem board 200 in the lower case 100, a display board 300 on the communication modem board 200, an upper case 400 on the lower case 100, an outer case 500 on the upper case 400.

The lower case 100 is rectangular substantially, with an opened top, to form a space therein, and the upper case 400 is rectangular substantially, with an opened bottom, to form a space therein, for coupling to an upper side of the lower case 100.

The communication modem board 200 is placed in the space of the lower case 100, and the display board 300 is mounted on the communication modem board 200, securely, or detachably.

The display board 300 has male terminal pins 310 at opposite edges, and the communication modem board 200 has female terminal pins 210 at opposite edges, wherein the display board 300 is electrically connected to, or disconnected from an upper side of the communication modem board 200 as male terminal pins 310 at opposite edges of the display board 300 are connected to, or disconnected from female terminal pins 210 at opposite edges of the communication modem board 200, respectively.

Of course, the display board 300 may have female terminal pins, and the communication modem board 200 may have male terminal pins, for the display board 300 to be electrically connected to, or disconnected from the upper side of the communication modem board 200.

The upper case 400 has a window 410 for showing an LCD segment 320, which is a display portion of the display board 300, and is detachably secured to the upper side of the lower case 100.

In this instance, the LCD segment 320 is detachably fastened to the display board 300 by a screw fastening system, or a hook fastening system, for displaying state information, such as a course progress, a cycle time period, and so on of the home appliance with numerals, characters, and so on.

The outer case 500 has a display window 510 in conformity with the window 410 of the upper case 400, and detachably secured to an upper side of the upper case 400.

Structures of the lower case 100, the upper case 400, and the outer case 500 will be described in more detail.

The outer case 500 has downward fastening bosses 520 at corners of a bottom surface which is a non-exposed surface, the upper case 400 has pass through holes 420 for the fastening bosses 520, and the lower case 100 has fastening holes 120 in upward projections toward an upper side thereof which is a non-exposed surface.

Accordingly, the outer case 500, the upper case 400, and the lower case 100 are assembled at a time, as screws 'S', fastening members, are fastened to the fastening bosses 520 through the fastening holes 120 while forming threads respectively in a state the fastening bosses 520, passed through the pass through holes 420, are in contact with the fastening holes 120 respectively.

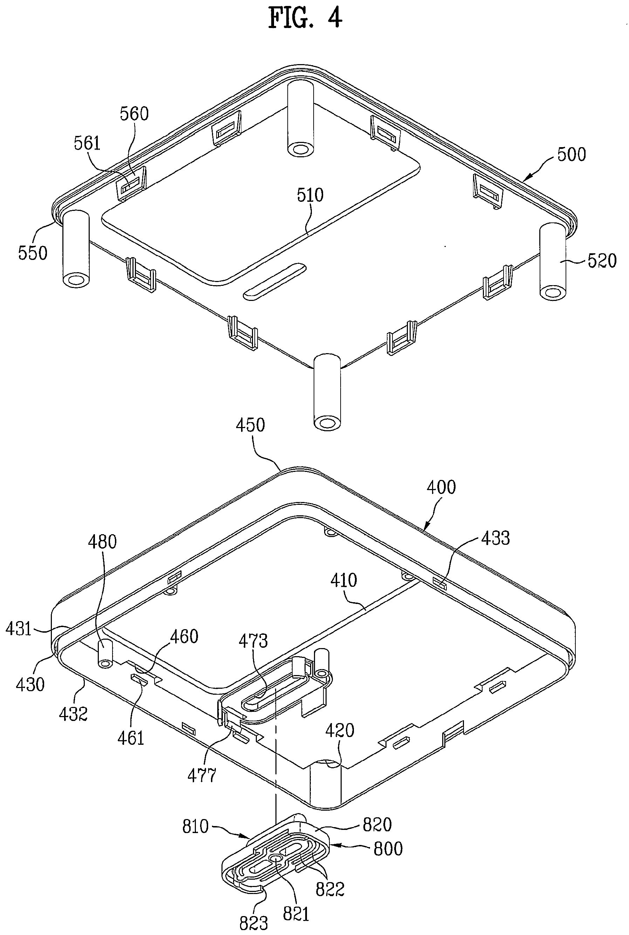

In the meantime, the lower case 100 has an upper rim 130 along an upper side circumference, and the upper case 400 has a lower groove 430 (see FIG. 4) along a lower side circumference to be engaged with the upper rim 130.

Of course, the upper case 400 may have a lower rim along a lower side circumference, and the lower case 100 may have an upper groove along an upper side circumference.

As the lower groove 430 is formed at a lower side circumference of the upper case 400, the upper case 400 becomes to have double shelled, with an outer rim 431 (see FIG. 4) on an outer side of the lower groove 130, and an inner rim 432 (see FIG. 4) on an inner side of the lower groove 130.

The inner rim 432 is projected longer than the outer rim 431, for enhancing a close contact capability of an inner side of the upper rim 130 with the inner rim 432, so that the upper case 400 and the lower case 100 are coupled firmly for protection of infiltration of water.

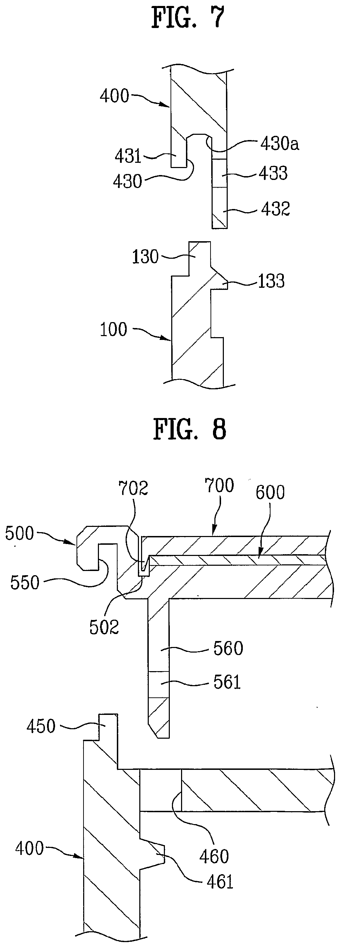

The lower groove 430 of the upper case 400 has a sealing portion 430a (see FIG. 7) where opposite edges of an end of the upper rim 130 are pressed down at the time the lower groove 430 is engaged with the upper rim 130.

The sealing portion 430a has sloped surfaces for pressing down the opposite edges of the end of the upper rim 130 thereon, respectively.

Moreover, the lower case 100 has a plurality of hooks 133 (see FIG. 7) at regular intervals along an inner side surface of the upper rim 130, and the upper case 400 has a plurality of hook holes 433 (see FIG. 7) in the inner rim 432 at positions matched to the plurality of hooks 133 for engagement with the plurality of hooks 133.

Therefore, if the upper rim 130 of the lower case 100 is engaged with the lower groove 430 of the upper case 400, the hooks 133 on the lower case 100 are engaged with the hook holes 433 in the upper case 400, thereby making the upper, and lower case coupled firmly.

In the meantime, referring to FIG. 4, the upper case 400 has an upper rim 450 along an upper side circumference, and the outer case 500 has a lower groove 550 for engagement with the upper rim 450.

The outer case 500 has holding portions 560 each having a hook hole 561 projected downward from an inner side of the circumference of a lower surface.

The upper case 400 also has slots 460 for pass through of the holding portions 560 respectively, and, along with this, hooks 461 for engagement with the hook holes 561 in the holding portions 560.

The holding portions 560 are formed at regular intervals along the circumference of the outer case 500.

Accordingly, when the holding portions 560 of the outer case 500 pass through the slots in the upper case 400, the hook holes 561 in the holding portions 560 are hooked at the hooks 461 on the upper case 400, respectively.

At the same time with this, if the upper rim 450 on the upper side circumference of the upper case 400 is engaged with the lower groove 550 of the outer case 500, the upper case 400 is coupled to the outer case 500, firmly.

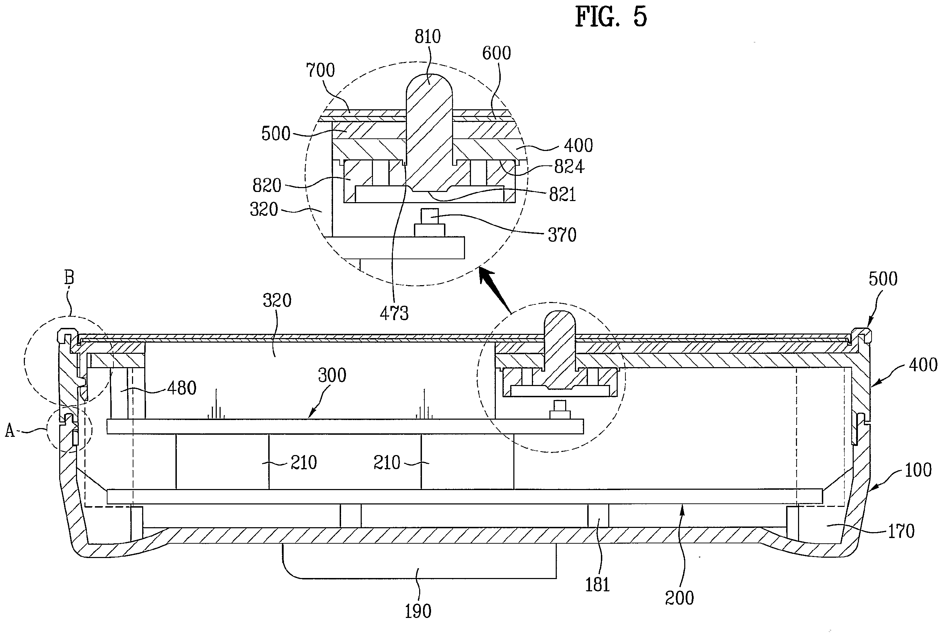

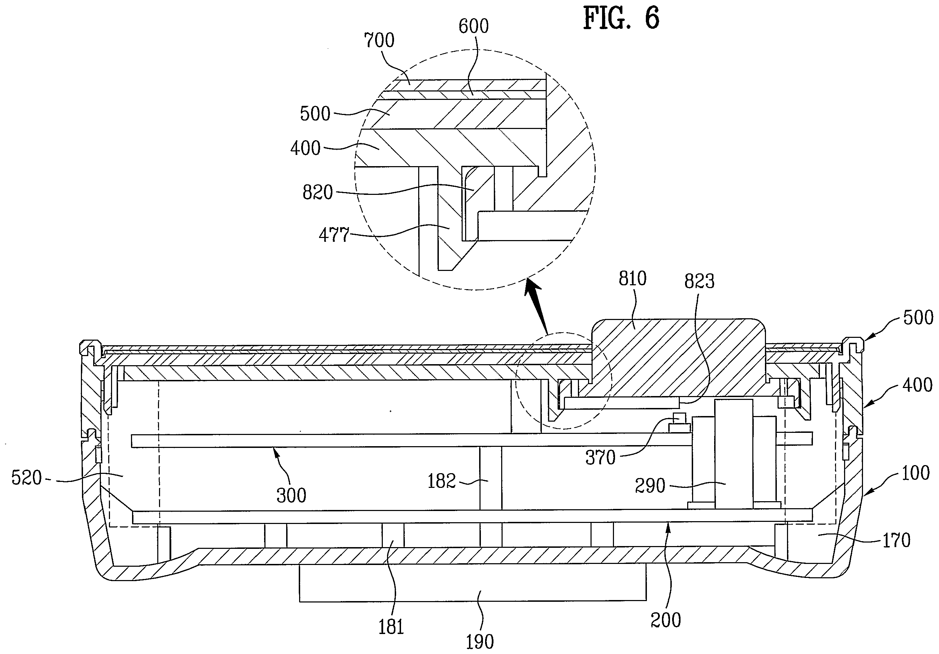

In the meantime, referring to FIGS. 5 and 6, the outer case 500 has a see-through sheet 600 of resin, such as PET (polyethylene terephthalate) on an upper surface, which is an exposed surface, for looking through the display window 510.

On an upper surface of the see-through sheet 600, there is a protective sheet 700 of a light metal, such as aluminum, having a see-through window 710 in correspondence to the display window 510 of the outer case 500.

The see-through sheet 600, and the protective sheet 700 have sizes in conformity with a size of the upper surface of the outer case 500.

Of course, the see-through sheet 600 may have a size corresponding to a size of the display window 510 of the outer case 500, and the protective sheet 700 may have a size corresponding to the upper surface of the outer case 500.

In this instance, referring to FIG. 8, the outer case 500 has an interference preventive groove 502 in a periphery of the upper surface, for preventing the protective sheet 700 from coming off the upper surface due to interference with a possible burr 702 from a fabrication process (for an example, cutting with a press) of the protective sheet 700.

Moreover, it is preferable that the periphery of the outer case 500 is plated with, such as chrome, for preventing corrosion, wear, and maintaining the periphery glossy.

In the meantime, referring to FIGS. 5 and 6, a structure in which the communication modem board 200 and the display board 300 are held inside of the upper and lower cases 400, and 100 will be described in more detail.

The communication modem board 200 and the display board 300 are mounted inside of the upper, and lower cases 400, and 100 in a state the communication modem board 200 and the display board 300 are coupled together.

The lower case 100 has "L" shaped guide ribs 170 (see FIG. 3) on an edge of an upper surface, which is unexposed, for placing the communication modem board 200 at a position spaced a predetermined height from the upper surface of the lower case 100, and preventing the communication modem board 200 from shaking.

There are a plurality of guide ribs 170 along the edge of the upper surface of the lower case 100 at predetermined intervals.

The lower case 100 has a plurality of lower supporting bosses 181 on the upper surface for supporting the communication modem board 200.

The lower supporting bosses 181 are mostly distributed at a position opposite to a central region of the communication modem board 200, and each has a flat projection end, for close contact with an underside surface of the communication modem board 200.

Moreover, it is preferable that the lower supporting bosses 181 are distributed concentrated opposite to a region around a tact switch 370, for preventing the communication modem board 200 from being pressed down to one side as the tact switch 370 on the display board 300 over the communication modem board 200 is pressed.

Along with this, the lower case 100 has a supporting pin 182 on the upper surface for direct supporting of the display board 300 for preventing the display board 300 itself from tilting as the switch 370 on the display board 300 is pressed.

That is, the supporting pin 182 is passed through a hole in the communication modem board 200, and has an end surface in close contact with the underside of the display board 300.

In this instance, it is preferable that the supporting pin 182 has a flat end, and is formed opposite to a region around the switch 370 of the display board 300.

Along with the lower supporting bosses 181 for supporting the communication modem board 200, the upper case 400 has a plurality of upper supporting bosses 480 (see FIG. 4) on a lower surface, which is unexposed surface, for supporting the display board 300.

The upper supporting bosses 480 have flat projection ends for making close contact with, and supporting the upper surface of the display board 300, and are mostly distributed at a position corresponding to a periphery region of the display board 300.

That is, it is preferable that the upper supporting bosses 480 are formed around the window 410 of the upper case 400, a position opposite to the upper surface of around the LCD segment 320 of the display board 300.

In the meantime, there is an operation button 800 for pressing down the tact switch 370 on the display board 300 from an outside of the remote monitor.

That is, referring to FIG. 3, the upper case 400 has a button hole 470 for placing the operation button 800 therein, and the outer case 500 has a communication hole 570 in correspondence to the button hole 470.

Moreover, the see-through sheet 600 and the protective sheet 700 have matched holes 670, and 770 matched to the communication hole 570.

Accordingly, the operation button 800, mounted such that a portion thereof is exposed through the button hole 470, the communication hole 570 and the matched holes 670, and 770, is configured to presses the tact switch 370 as the operation button 1800 is pressed from an outside, and return to an original position, again.

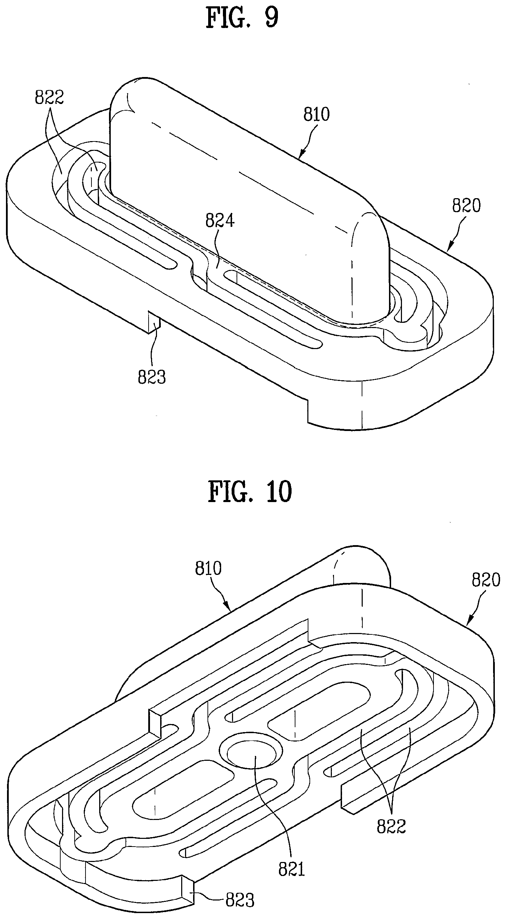

Referring to FIGS. 9 and 10, the operation button 800 includes a pressing portion 810 exposed to an outside of the remote monitor for enabling operation through the button hole 470 and the communication hole 570 in the upper case 400, and a mounting portion 820 formed as one body with the pressing portion 810 at a lower portion for being held at an underside of the upper case 400.

There are hooks 477 projected from the underside of the upper case 400 at opposite sides of the button hole 470, so that the operation button 800 is secured to the upper case 400 as the operation button 800 has bottom edges of the mounting portion 820 hooked at the hooks 477 (see FIG. 6).

The mounting portion 820 has a contact projection 821 at a central portion for being brought into contact with the tact switch 370 when the operation button 800 is pressed.

Moreover, the mounting portion 820 has elastic ribs 822 of a plurality of slots on a periphery for providing restoring force to the operation button 800.

Furthermore, the mounting portion 820 has an interference avoidance slot 823 at a bottom circumference for preventing the operation button 800 from interfering with an electronic component 290 (see FIG. 6) on the communication modem board 200 in the vicinity of the tact switch 370 at the time of mounting the operation button 800.

Since the operation button 800 is symmetry in both directions, it is preferable that the interference avoidance slots 823 are formed at opposite sides of the circumference of the mounting portion 820 symmetrically, for preventing the operation button 800 from interfering with the electronic component even if the operation button 800 is mounted in an opposite direction by mistake.

In the meantime, the upper case 400 has a downward stepped portion 473 (see FIG. 5) around the button hole 470, and the mounting portion 820 of the operation button 800 has a counter stepped portion 824 (see FIG. 5) projected opposite to the stepped portion such that the counter stepped portion 824 is in close contact with an underside of the upper case 400 when the operation button 800 is mounted.

It is preferable that the counter stepped portion 824 has a projected length the same with a projected length of the stepped portion 473, so that the counter stepped portion 824 is brought into close contact with the underside of the upper case 400 when the operation button 800 is mounted.

Accordingly, when the operation button 800 is mounted in the button hole 470 of the upper case 400, since the counter stepped portion 824 of the operation button 800 is brought into close contact with the under side of the upper case 400 while surrounding the stepped portion 473 of the upper case 400, the counter stepped portion 824 can prevent infiltration of water through the button hole 470.

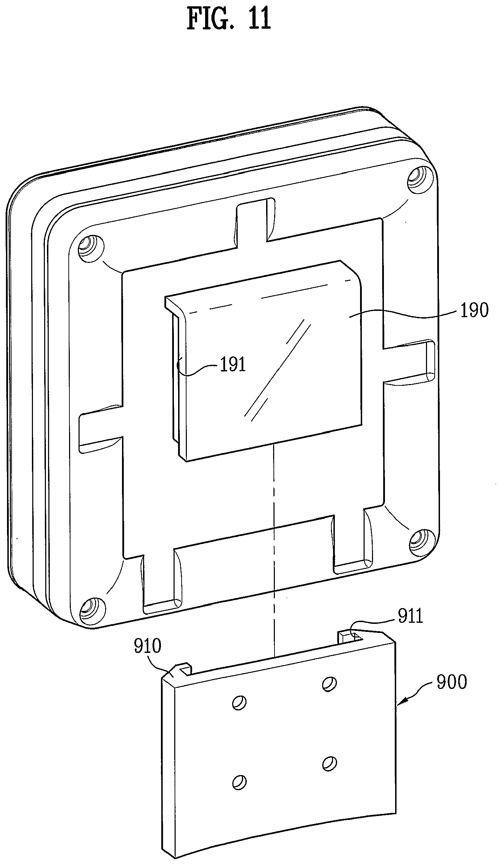

In the meantime, referring to FIG. 11, the remote monitor 1 can be mounted on a user's desired place by means of separate securing means.

That is, the remote monitor 1 may be mounted on a wall or the like of a living room where the user stays most of the time.

The securing means includes a substantially rectangular mounting portion 190 projected from a central portion of a bottom which is an exposed side of the lower case 100 of the remote monitor 1, and a hanger 900 to be fixedly secured to the wall the remote monitor 1 is to be mounted thereon for placing the mounting portion 190 thereon.

The mounting portion 190 has guide projections 191 on opposite sides, and the hanger 900 has seating portions 910 on opposite sides, each having a guide groove in an inside for slidably placing the guide projections 191 therein.

Therefore, the remote monitor 1 can be mounted readily, if the guide projections 191 on the mounting portion 190 of the lower case 100 are slidably placed in the guide grooves 911 on the seating portions 910 of the hanger 900 after the hanger 900 is fixedly secured to the wall with fastening members, such as bolts.

In this instance, in light of a fine view, it is preferable that a size of the hanger 900 is smaller than a size of the lower case 100 so that the hanger 900 is invisible when the remote monitor 1 is seen from a front.

In the meantime, referring to FIG. 3, the outer case 500 has shrinkage preventive grooves 501 in an upper surface which is an exposed surface of the outer case, for preventing the fastening bosses 520 from shrinking at the time of injection molding by using a mold.

The shrinkage preventive grooves 501 are formed in corners of the upper surface of the upper case 500 where the fastening bosses 520 are, each in a shape of a ring having an axis the same with a longitudinal axis of the fastening boss 520.

According to this, the outer case 500 can substantially spread shrinking force acting on the fastening boss 520 at the time of injection molding with a mold to the shrinkage preventive groove 501, for preventing the fastening boss 520 from shrinking in advance.

The lower case 100 has slide portions 101 at the upper surface which is an unexposed surface of the lower case 100, for removing a mold without interference with the hooks 133 on the lower case 100 at the time of injection molding of the lower case 100 with the mold.

The slide portion 101 is a flat portion extended from an edge of the upper surface of the lower case 100 to a circumference of the lower case 100 under the hook 133.

Of course, a number of the slide portion 101 is the same with a number of the hooks 133.

The slide portions 101 of the lower case 100 enable smooth upward removal of the mold without interference with the hooks 133 after the mold is moved to a central side of the lower case 100 through the slide portions 101.

In the meantime, though not shown, the remote monitor 1 may be provided with a speaker for remote display as well as announcing a state of progress of a home appliance with a sound.

That is, if a sound designated for a state of progress of the home appliance is provided through the speaker, the user can notice the state of progress and an error state only with the sound, enabling the user to make an appropriate maintenance and control of the home appliance.

A process for assembling the remote monitor 1 will be described with reference to FIGS. 3 to 10.

Referring to FIG. 3, the male terminal pin 310 of the display board 300 is placed in the female terminal pin 210 of the communication modem board 200, to mount, and electrically connect the display board 300 onto the communication modem board 200.

The mounting of the display board 300 on the communication modem board 200 in a fashion of stacking enables to minimize mounting spaces of the communication modem board 200 and the display board 300, thereby enabling to make a size of the remote monitor 1 smaller.

Then, a control board having the display board 300 mounted on the communication modem board 200 is placed on the guide ribs 170 of the lower case 100.

The guide ribs 170, substantially in "L" shapes in conformity with the circumference of the communication modem board 200, enables mounting of the control board in an inside space of the lower case 100 at a predetermined height, and preventing the control board from shaking.

In the meantime, referring to FIG. 4, the operation button 800 is placed in the button hole 470 in the upper case 400, wherein the operation button 800 is held in the button hole 470 firmly by the hooks 477 on the upper case 400.

In this instance, referring to FIG. 5, the stepped portion 473 on the button hole 470 of the upper case 400 and the counter stepped portion 824 on the operation button 800, which is in close contact with the underside of the upper case 400 while surrounding the stepped portion 473, prevent infiltration of water through the button hole 470.

Moreover, referring to FIG. 6, the operation button 800 has the interference avoidance slot 823 for preventing the operation button 800 from interfering with various electronic components of the control board in the lower case.

Therefore, the upper case 400 can be mounted on the lower case 100 smoothly without interference between the operation button 800 and the various electronic components 290 on the control board in the lower case 100.

In the meantime, the see-through sheet 600 and the protective sheet 700 on the upper surface of the upper case 400 are attached thereto with two side tapes, or adhesive.

The interference preventive groove 502 in the periphery of the upper surface of the outer case 500, formed to prevent interference with burrs 702 (see FIG. 8) left in a fabrication process of the protective sheet 700, prevents the protective sheet 700 from coming off the upper surface of the outer case 500 in advance.

Thereafter, the upper case 400, and the outer case 500 are positioned on the lower case 100 in succession, and secured thereto, which will be described in more detail.

At first, the upper case 400 is coupled to the lower case 100 by placing the upper rim 130 (see FIG. 7) of the lower case 100 in the lower groove 430 (see FIG. 7) of the upper case 400.

Then, the hooks 131 on the inside surface of the upper rim 130 are held at the hook holes 431 in the lower groove 430, to couple the upper case 400 to the lower case 100, firmly.

The sealing portions 430a in the lower groove 430 where end edges of the upper rim 130 are to be pressed down thereon prevent infiltration of water through circumferences of the upper case 400 and the lower case 100, which come into contact when the upper case 400 and the lower case 100 are coupled.

In the meantime, an upper surface of the LCD segment 320 (see FIG. 5) on the display board 300 is exposed to an outside matched to the window 410 in the upper case 400.

Next, referring to FIG. 4, the outer case 500 is coupled to an upper side of the upper case 400 as the upper rim 450 of the upper case 400 is placed in the lower groove 550 in the outer case 500.

At the same time with this, the holding portions 560 on the outer case 500 pass through the slots 460 in the upper case 400, and the hook holes 561 in the holding portions 560 are engaged with the hooks 461 on the upper case 400, thereby coupling the outer case 500 to the upper case 400, firmly.

In this instance, referring to FIG. 5, the upper surface of the LCD segment 320 exposed through the window 410 of the upper case 400 is exposed through the display window 510 of the outer case 500 through the see-through sheet 600 on the outer case 500.

Moreover, the outer case 500 has the communication hole 570 in communication with the button hole 470, wherein the operation button 800 is made operable as the operation button 800 is projected outwardly through the button hole 470 and the communication hole 570.

In the meantime, referring to FIG. 3, the lower case 100, the upper case 400, and the outer case 500 are coupled together thus, and fastened with fastening screws 'S' in a state the fastening bosses 520 are passed through the pass through holes 420 in the upper case 400 and in contact with the fastening holes 120 in the lower case 100.

According to this, steps between the cases 100, 400, and 500 required for assembly of the cases 100, 400, and 500 can be minimized, and the cases 100, 400, and 500 can be assembled at a time, easily.

In the meantime, referring to FIGS. 5 and 6, the communication modem board 200 and the display board 30 are supported on the upper, and lower supporting bosses 181 within the upper and lower cases 400, and 100 firmly.

That is, the display board 300 is supported by the upper supporting bosses 480 on the upper case 400, and the communication modem board 200 is supported on the lower supporting bosses 181 on the lower case 100.

Moreover, the lower case 100 also has the supporting pin 182 for passing through the communication modem board 200 and supporting the display board 300.

Therefore, even if the switch 370 on the display board 300 is pressed down through the operation button 800, the supporting pin 182 prevents the display board 300 from tilting in advance.

A mounting process of the remote monitor 1 assembled thus will be described with reference to FIG. 11.

In order to mount the remote monitor 1, the hanger 900 is fixedly secured to a wall of a place the user desires with fastening members, such as bolts.

Then, upon slidably placing the guide projections 191 on the mounting portions 190 of the remote monitor 1 in the guide grooves 911 in the seating portions 910 of the hanger 900 in an up/down direction, the remote monitor 1 is held at the wall of the place the user desires by the hanger 900.

In this instance, since the hanger 900 has a size smaller than a whole size of the remote monitor 1, the hanger 900 is invisible when the user looks at the remote monitor 1, and the outer case 500 of the remote monitor 1 has fine view with the chrome plating on the periphery for preventing scratching, wearing down, and so on.

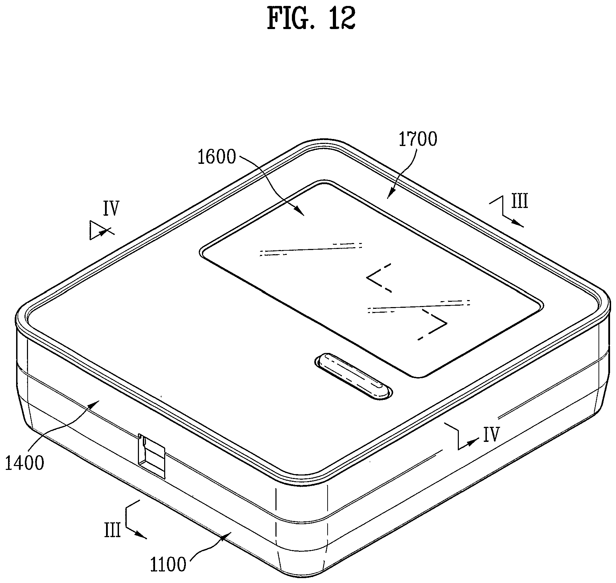

A remote monitor in accordance with a second preferred embodiment of the present invention will be described with reference to FIGS. 12 to 21.

Referring to FIG. 12, the remote monitor 10 includes an upper case 1400 which also can function as the outer case 500 (see FIG. 3) of the remote monitor 1 (see FIG. 1) of the first embodiment.

The remote monitor 10 is also connected to home appliances, such as the washing machine 2 (see FIG. 1) and a dryer 3 (see FIG. 1), with power line for transmission/reception of data by a power line communication system.

The remote monitor 10 will be described in more detail.

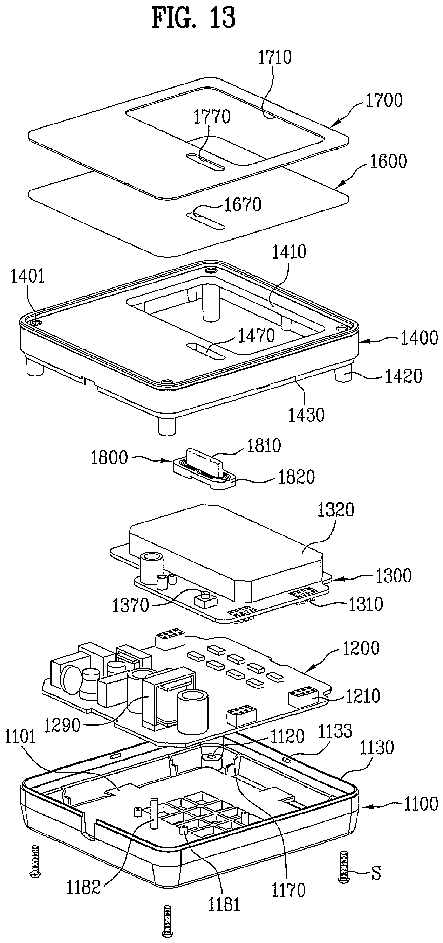

Referring to FIG. 13, the remote monitor 10 includes a lower case 1100, a control board mounted on the lower case 1100, having a communication modem board 1200 and a display board 1300, and an upper case 1400 on the lower case 1100.

The lower case 1100 is substantially rectangular, with an opened top to form a space therein, and the upper case 1400 is substantially rectangular, with an opened bottom to form a space therein, and detachably coupled to an upper side of the lower case 1100.

The communication modem board 1200 is placed in an inside space of the lower case 1100, and the display board 1300 is mounted on the communication modem board 1200, fixedly, or detachably.

The display board 1300 has male terminal pins 1310 at opposite edges, and the communication modem board 1200 has female terminal pins 1210 at opposite edges, wherein the display board 1300 is electrically connected to, or disconnected from an upper side of the communication modem board 1200 as male terminal pins 310 at opposite edges of the display board 1300 are connected to, or disconnected from female terminal pins 1210 at opposite edges of the communication modem board 1200, respectively.

Of course, the display board 1300 may have female terminal pins, and the communication modem board 1200 may have male terminal pins, for the display board 1300 to be electrically connected to, or disconnected from the upper side of the communication modem board 1200.

The upper case 1400 has a window 1410 for showing an LCD segment 320, which is a display portion of the display board 1300, and is detachably secured to the upper side of the lower case 1100.

In this instance, the LCD segment 1320 is detachably fastened to the display board 1300 by a screw fastening system, or a hook fastening system, for displaying state information, such as a course progress, a cycle time period, and so on of the home appliance with numerals, characters, and so on.

Structures of the upper case 1400, and the lower case 1100 will be described in more detail.

The upper case 1400 has downward fastening bosses 1420 at corners of a bottom surface which is a non-exposed surface, and the lower case 1100 has fastening holes 1120 in upward projections toward an upper side thereof which is a non-exposed surface.

Accordingly, the upper case 1400, and the lower case 1100 are assembled at a time, as screws 'S', fastening members, are fastened to the fastening bosses 1420 through the fastening holes 1120 while forming threads respectively in a state the fastening bosses 1420 are in contact with the fastening holes 1120, respectively

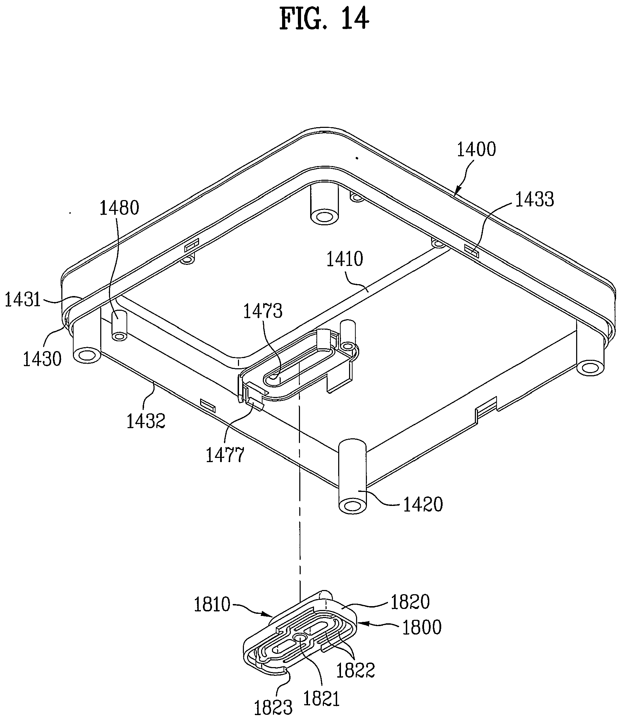

In the meantime, the lower case 1100 has an upper rim 1130 along an upper side circumference, and the upper case 1400 has a lower groove 1430 (see FIG. 14) along a lower side circumference to be engaged with the upper rim 1130.

Of course, the upper case 1400 may have a lower rim along a lower side circumference, and the lower case 1100 may have an upper groove along an upper side circumference.

As the lower groove 1430 is formed at a lower side circumference of the upper case 1400, the upper case 1400 becomes to have double shelled, with an outer rim 1431 (see FIG. 14) on an outer side of the lower groove 1130, and an inner rim 1432 (see FIG. 14) on an inner side of the lower groove 1130.

The inner rim 1432 is projected longer than the outer rim 1431, for enhancing a close contact capability of an inner side of the upper rim 1130 with the inner rim 432, so that the upper case 1400 and the lower case 1100 are coupled more firmly for protection of infiltration of water.

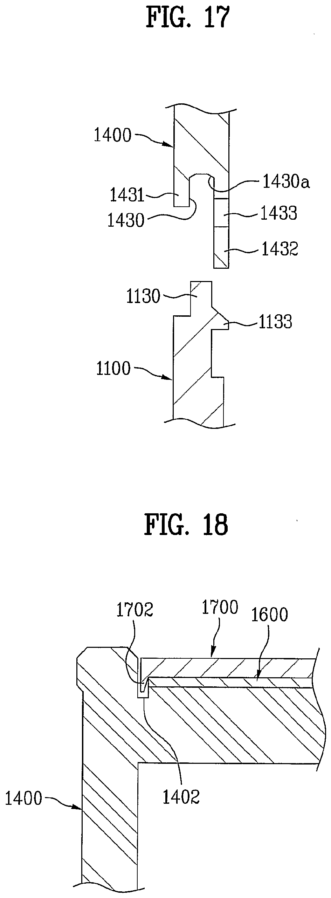

The lower groove 1430 of the upper case 1400 has a sealing portion 1430a (see FIG. 17) where opposite edges of an end of the upper rim 1130 are pressed down at the time the lower groove 1430 is engaged with the upper rim 1130.

The sealing portion 1430a has sloped surfaces for pressing down the opposite edges of the end of the upper rim 1130 thereon, respectively.

Moreover, the lower case 1100 has a plurality of hooks 1133 (see FIG. 17) at regular intervals along an inner side surface of the upper rim 1130, and the upper case 1400 has a plurality of hook holes 1433 (see FIG. 17) in the inner rim 1432 at positions matched to the plurality of hooks 1133 for engagement with the plurality of hooks 1133.

Therefore, if the upper rim 1130 of the lower case 1100 is engaged with the lower groove 1430 of the upper case 1400, the hooks 1133 on the lower case 1100 are engaged with the hook holes 1433 in the upper case 1400, thereby making the upper, and lower case coupled, firmly.

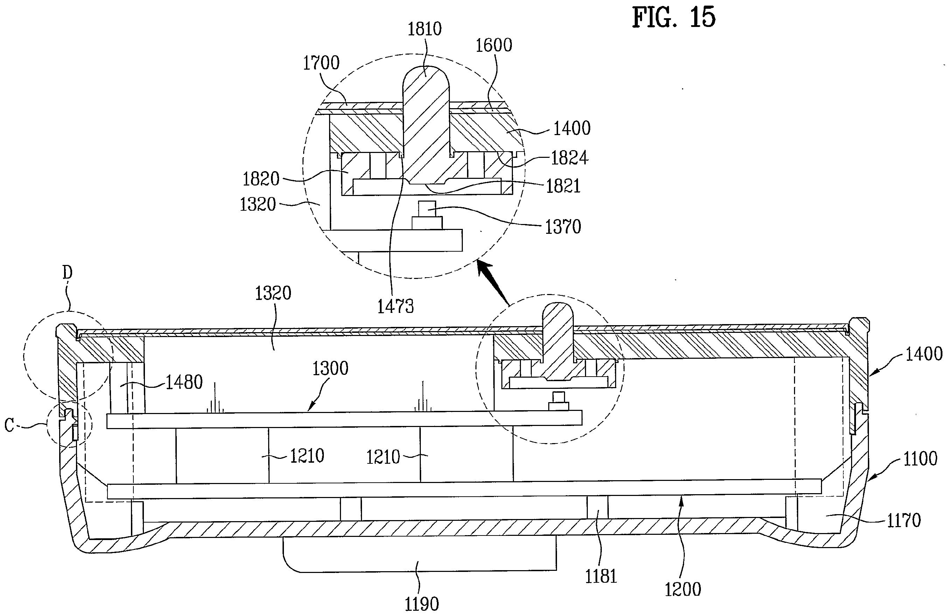

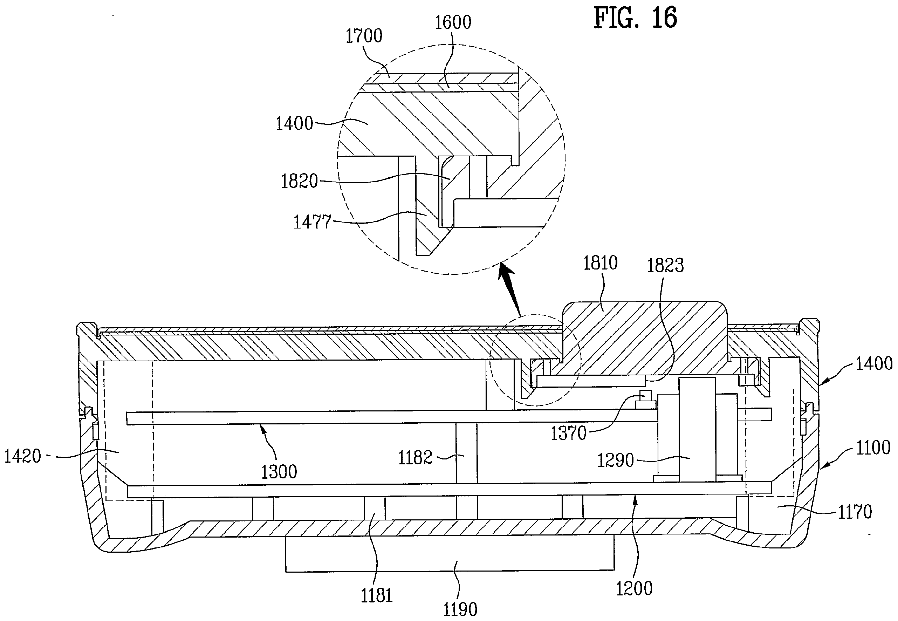

In the meantime, referring to FIGS. 15 and 16, the upper case 1400 has a see-through sheet 1600 of resin, such as PET (polyethylene terephthalate) on an upper surface, which is an exposed surface, for looking through the window 1410.

On an upper surface of the see-through sheet 1600, there is a protective sheet 1700 of a light metal, such as aluminum, having a see-through window 1710 in correspondence to the window 1410 of the upper case 1400.

The see-through sheet 1600, and the protective sheet 1700 have sizes in conformity with a size of the upper surface of the upper case 1400.

Of course, the see-through sheet 1600 may have a size corresponding to a size of the window 1410 of the upper case 1400, and the protective sheet 1700 may have a size corresponding to the upper surface of the upper case 1400.

In this instance, referring to FIG. 18, the upper case 1400 has an interference preventive groove 1402 in a periphery of the upper surface, for preventing the protective sheet 1700 from coming off the upper surface due to interference with a possible burr 1702 from a fabrication process (for an example, cutting with a press) of the protective sheet 1700.

Moreover, it is preferable that the periphery of the upper surface of the upper case 1400 is plated with, such as chrome, for preventing corrosion, wear, and maintaining the periphery glossy.

In the meantime, referring to FIGS. 15 and 16, a structure in which the communication modem board 1200 and the display board 1300 are held inside of the upper and lower cases 1400, and 1100 will be described in more detail.

The communication modem board 1200 and the display board 1300 are mounted inside of the upper, and lower cases 1400, and 1100 in a state the communication modem board 1200 and the display board 1300 are coupled together.

The lower case 1100 has "L" shaped guide ribs 1170 (see FIG. 13) on an edge of an upper surface, which is unexposed, for placing the communication modem board 1200 at a position spaced a predetermined height from the upper surface of the lower case 1100, and preventing the communication modem board 1200 from shaking.

There are a plurality of guide ribs 1170 along the edge of the upper surface of the lower case 1100 at predetermined intervals.

The lower case 1100 has a plurality of lower supporting bosses 1181 on the upper surface for supporting the communication modem board 1200.

The lower supporting bosses 1181 are mostly distributed at a position opposite to a central region of the communication modem board 1200, and each has a flat projection end, for close contact with an underside surface of the communication modem board 1200.

Moreover, it is preferable that the lower supporting bosses 1181 are distributed concentrated opposite to a region around a tact switch 1370, for preventing the communication modem board 1200 from being pressed down to one side as the tact switch 1370 on the display board 1300 over the communication modem board 1200 is pressed.

Along with this, the lower case 1100 has a supporting pin 1182 on the upper surface for direct supporting of the display board 1300 for preventing the display board 1300 itself from tilting as the switch 1370 on the display board 1300 is pressed.

That is, the supporting pin 1182 is passed through a hole in the communication modem board 1200, and has an end surface in close contact with the underside of the display board 1300.

In this instance, it is preferable that the supporting pin 1182 has a flat end, and is formed opposite to a region around the switch 1370 of the display board 1300.

Along with the lower supporting bosses 1181 for supporting the communication modem board 1200, the upper case 1400 has a plurality of upper supporting bosses 1480 (see FIG. 14) on a lower surface, which is unexposed surface, for supporting the display board 1300.

The upper supporting bosses 1480 have flat projection ends for making close contact with, and supporting the upper surface of the display board 1300, and are mostly distributed at a position corresponding to a periphery region of the display board 1300.

That is, it is preferable that the upper supporting bosses 1480 are formed around the window 1410 of the upper case 1400, a position opposite to the upper surface of around the LCD segment 1320 of the display board 1300.

In the meantime, there is an operation button 1800 for pressing down the tact switch 1370 on the display board 300 from an outside of the remote monitor.

That is, referring to FIG. 13, the upper case 1400 has a button hole 1470 for placing the operation button 1800 therein.

Moreover, the see-through sheet 1600 and the protective sheet 1700 have matched holes 1670, and 1770 matched to the button hole 1470.

Accordingly, the operation button 1800, mounted such that a portion thereof is exposed through the button hole 1470, and the matched holes 1670, and 1770, is configured to presses the tact switch 1370 as the operation button 1800 is pressed from an outside, and return to an original position, again.

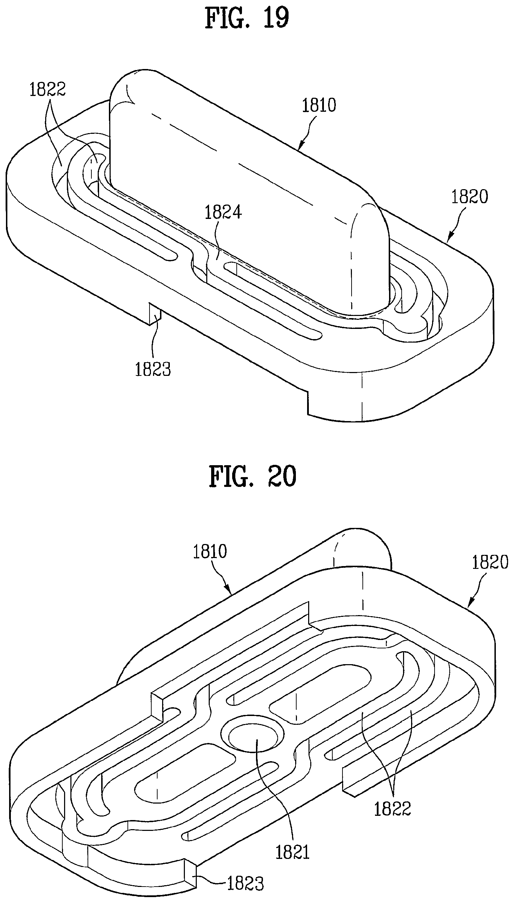

Referring to FIGS. 19 and 20, the operation button 1800 includes a pressing portion 1810 exposed to an outside of the remote monitor for enabling operation through the button hole1 470 in the upper case 1400, and a mounting portion 1820 formed as one body with the pressing portion 1810 at a lower portion for being held at an underside of the upper case 1400.

There are hooks 1477 projected from the underside of the upper case 1400 at opposite sides of the button hole 1470, so that the operation button 1800 is secured to the upper case 1400 as the operation button '800 has bottom edges of the mounting portion 1820 hooked at the hooks 1477 (see FIG. 16).

The mounting portion 1820 has a contact projection 1821 at a central portion for being brought into contact with the tact switch 1370 when the operation button 1800 is pressed.

Moreover, the mounting portion 1820 has elastic ribs 1822 of a plurality of slots on a periphery for providing restoring force to the operation button 1800.

Furthermore, the mounting portion 1820 has an interference avoidance slot 1823 at a bottom circumference for preventing the operation button 1800 from interfering with an electronic component 1290 (see FIG. 16) on the communication modem board 1200. in the vicinity of the tact switch 1370 at the time of mounting the operation button 1800.

Since the operation button 1800 is symmetry in both directions, it is preferable that the interference avoidance slots 1823 are formed at opposite sides of the circumference of the mounting portion 1820 symmetrically, for preventing the operation button 1800 from interfering with the electronic component even if the operation button 1800 is mounted in an opposite direction by mistake.

In the meantime, the upper case 1400 has a downward stepped portioln 473 (see FIG. 15) around the button hole 1470, and the mounting portion 1820 of the operation button 1800 has a counter stepped portion 1824 (see FIG. 15) projected opposite to the stepped portion such that the counter stepped portion 1824 is in close contact with an underside of the upper case 1400 when the operation button 1800 is mounted.

It is preferable that the counter stepped portion 1824 has a projected length the same with a projected length of the stepped portion 1473, so that the counter stepped portion 1824 is brought into close contact with the underside of the upper case 1400 when the operation button 1800 is mounted.

Accordingly, when the operation button 1800 is mounted in the button hole 1470 of the upper case 1400, since the counter stepped portion 1824 of the operation button 1800 is brought into close contact with the under side of the upper case 1400 while surrounding the stepped portion 1473 of the upper case 1400, the counter stepped portion 1824 can prevent infiltration of water through the button hole 1470.

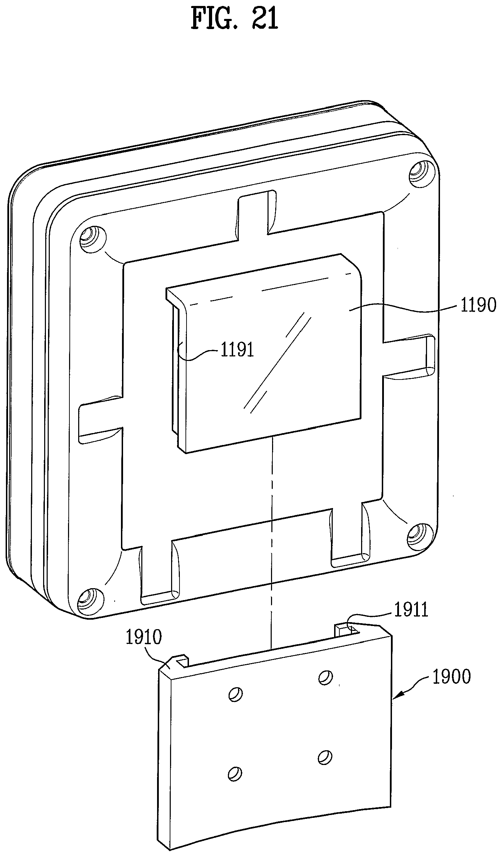

In the meantime, referring to FIG. 21, the remote monitor 10 can be mounted on a user's desired place by means of separate securing means.

That is, the remote monitor 10 may be mounted on a wall or the like of a living room where the user stays most of the time.

The securing means includes a substantially rectangular mounting portion 1190 projected from a central portion of a bottom which is an exposed side of the lower case 1100 of the remote monitor 10, and a hanger 1900 to be fixedly secured to the wall the remote monitor 10 is to be mounted thereon for placing the mounting portion 1190 thereon.

The mounting portion 1190 has guide projections 1191 on opposite sides, and the hanger 1900 has seating portions 1910 on opposite sides, each having a guide groove in an inside for slidably placing the guide projections 1191 therein.

Therefore, the remote monitor 10 can be mounted readily, if the guide projections 1191 on the mounting portion 1190 of the lower case 1100 are slidably placed in the guide grooves 1911 on the seating portions 1910 of the hanger 1900 after the hanger 1900 is fixedly secured to the wall with fastening members, such as bolts.

In this instance, in light of a fine view, it is preferable that a size of the hanger 1900 is smaller than a size of the lower case 1100 so that the hanger 1900 is invisible when the remote monitor 10 is seen from a front.

In the meantime, referring to FIG. 13, the upper case 1400 has shrinkage preventive grooves 1401 in an upper surface which is an exposed surface of the upper case, for preventing the fastening bosses 1420 from shrinking at the time of injection molding by using a mold.

The shrinkage preventive grooves 1401 are formed in corners of the upper surface of the upper case 1400 where the fastening bosses 1420 are, each in a shape of a ring having an axis the same with a longitudinal axis of the fastening boss 1420.

According to this, the upper case 1400 can substantially spread shrinking force acting on the fastening boss 1420 at the time of injection molding with a mold to the shrinkage preventive groove 1401, for preventing the fastening boss 1420 from shrinking in advance.

The lower case 1100 has slide portions 1101 at the upper surface which is an unexposed surface of the lower case 1100, for removing a mold without interference with the hooks 1133 on the lower case 1100 at the time of injection molding of the lower case 1100 with the mold.

The slide portion 1101 is a flat portion extended from an edge of the upper surface of the lower case 1100 to a circumference of the lower case 1100 under the hook 1133.

Of course, a number of the slide portion 1101 is the same with a number of the hooks 1133.

The slide portions 1101 of the lower case 1100 enable smooth upward removal of the mold without interference with the hooks 1133 after the mold is moved to a central side of the lower case 1100 through the slide portions 1101.

In the meantime, though not shown, the remote monitor 10 may be provided with a speaker for remote display as well as announcing a state of progress of a home appliance with a sound.

That is, if a sound designated for a state of progress of the home appliance is provided through the speaker, the user can notice the state of progress and an error state only with the sound, enabling the user to make an appropriate maintenance and control of the home appliance.

A process for assembling the remote monitor 10 will be described with reference to FIGS. 13 to 20.

Referring to FIG. 13, the male terminal pin 1310 of the display board 1300 is placed in the female terminal pin 1210 of the communication modem board 1200, to mount, and electrically connect the display board 1300 onto the communication modem board 1200.

The mounting of the display board 1300 on the communication modem board 1200 in a fashion of stacking enables to minimize mounting spaces of the communication modem board 1200 and the display board 1300, thereby enabling to make a size of the remote monitor 10 smaller.

Then, a control board having the display board 1300 mounted on the communication modem board 1200 is placed on the guide ribs 1170 of the lower case 1100.

The guide ribs 1170, substantially in "L" shapes in conformity with the circumference of the communication modem board 1200, enable mounting of the control board in an inside space of the lower case 1100 at a predetermined height, and preventing the control board from shaking.

In the meantime, referring to FIG. 14, the operation button 1800 is placed in the button hole 1470 in the upper case 1400, wherein the operation button 1800 is held in the button hole 1470 firmly by the hooks 1477 on the upper case 1400.

In this instance, referring to FIG. 15, the stepped portion 1473 on the button hole 1470 of the upper case 1400 and the counter stepped portion 1824 on the operation button 1800, which is in close contact with the underside of the upper case 1400 while surrounding the stepped portion 1473, prevent infiltration of water through the button hole 1470.

Moreover, referring to FIG. 16, the operation button 1800 has the interference avoidance slot 1823 for preventing the operation button 1800 from interfering with various electronic components of the control board in the lower case.

Therefore, the upper case 1400 can be mounted on the lower case 100 smoothly without interference between the operation button 1800 and the various electronic components 1290 on the control board in the lower case 1100.

In the meantime, the see-through sheet 1600 and the protective sheet 1700 on the upper surface of the upper case 1400 are attached thereto with two sided tapes, or adhesive.

The interference preventive groove 1402 in the periphery of the upper surface of the upper case 1400, formed to prevent interference with burrs 1702 (see FIG. 8) left in a fabrication process of the protective sheet 1700, prevents the protective sheet 1700 from coming off the upper surface of the upper case 1400 in advance.

The upper case 400 having the operation button 1800, the see-through sheet 1600, and the protective sheet 1700 is coupled to the lower case 1100 by placing the upper rim 1130 (see FIG. 17) of the lower case 1100 in the lower groove 1430 (see FIG. 17) of the upper case 1400.

Then, the hooks 1131 on the inside surface of the upper rim 130 are held at the hook holes 1431 in the lower groove 1430, to couple the upper case 1400 to the lower case 1100, firmly.

The sealing portions 1430a in the lower groove 1430 where end edges of the upper rim 1130 are to be pressed down thereon prevent infiltration of water through circumferences of the upper case 1400 and the lower case 1100, which come into contact when the upper case 1400 and the lower case 1100 are coupled.

In the meantime, an upper surface of the LCD segment 1320 (see FIG. 15) on the display board 1300 is exposed to an outside matched to the window 1410 in the upper case 1400.

In this instance, referring to FIG. 15, the upper surface of the LCD segment 1320 exposed through the window 1410 of the upper case 1400 is exposed through the window 1410 through the see-through sheet 1600 on the upper case 1400.

Moreover, the upper case 1400 has the button hole 1470, wherein the operation button 1800 is made operable from an outside as the operation button 1800 is projected outwardly through the button hole 1470.

In the meantime, referring to FIG. 13, the lower case 1100, and the upper case 1400 are coupled together thus, and fastened with fastening screws 'S' in a state the fastening bosses 1420 of the upper case 1400 are in contact with the fastening holes 1120 in the lower case 1100.

According to this, steps between the cases 1100, and 1400 required for assembly of the cases 1100, and 1400 can be minimized, and the cases 100, and 1400 can be assembled at a time, easily.

In the meantime, referring to FIGS. 15 and 16, the communication modem board 1200 and the display modem board 130 are supported on the upper, and lower supporting bosses 1181 within the upper and lower cases 1400, and 1100, firmly.

That is, the display board 1300 is supported by the upper supporting bosses 1480 on the upper case 1400, and the communication modem board 1200 is supported on the lower supporting bosses 1181 on the lower case 1100.

Moreover, the lower case 1100 also has the supporting pin 1182 for passing through the communication modem board1 200 and supporting the display board 1300.

Therefore, even if the switch 1370 on the display board 1300 is pressed down through the operation button 1800, the supporting pin 1182 prevents the display board 1300 from tilting in advance.

A mounting process of the remote monitor 10 assembled thus will be described with reference to FIG. 21.

In order to mount the remote monitor 10, the hanger 1900 is fixedly secured to a wall of a place the user desires with fastening members, such as bolts.

Then, upon slidably placing the guide projections 1191 on the mounting portions 1190 of the remote monitor 10 in the guide grooves 1911 in the seating portions 1910 of the hanger 1900 in an up/down direction, the remote monitor 10 is held at the wall of the place the user desires by the hanger 1900.

In this instance, since the hanger 1900 has a size smaller than a whole size of the remote monitor 10, the hanger 1900 is invisible when the user looks at the remote monitor 10, and the upper case 1400 of the remote monitor 10 has fine view with the chrome plating on the periphery for preventing scratching, wearing down, and so on.

In the meantime, in the first, or second embodiment, instead of mounting the communication modem board 100, or 1200 in the remote monitor 1 or 10, an external type modem may be provided for transmission and reception of data through the modem of the home appliance and the power line, for having identical effects with the present invention.

That is, the display board 300, or 1300 in the remote monitor 1, or 10 may be connected to the external type modem with a communication line, for transmission and reception of data, so that the external type modem transmits/receives data to/from the modem of the home appliance, and the display board 300, or 1300 displays the data to an outside.

It will be apparent to those skilled in the art that various modifications and variations can be made in the present invention without departing from the scope of the inventions. Thus, it is intended that the present invention covers the modifications and variations of this invention provided they come within the scope of the appended claims and their equivalents.

### [Industrial Applicability]

The remote monitor for a home appliance of the present invention has a distinctive industrial applicability in that user's easy and remote monitoring of a home appliance is permitted, enabling the user to take an appropriate measure at an appropriate time, thereby permitting effective maintenance and management of the home appliance, and effective management of things, such as laundry, used for the home appliance.

## Claims

1. A remote monitor (1; 10) for a home appliance, the remote monitor (1; 10) being connected to at least one home appliance with a predetermined communication system for displaying, and controlling of a state of the home appliance at a place far from the home appliance, comprising:
a case forming an outside appearance of the remote monitor (1; 10), including a lower case (100; 1100), and an upper case (400; 1400) detachably mounted on an upper side of the lower case (100; 1100), the upper case (400; 1400) having a window (410; 1410); and
a control board in the case, the control board having various electronic components mounted thereon,
wherein one of the upper case (400; 1400) and the lower case (100; 1100) includes a rim (130; 1130), and the other one includes a groove (430; 1430) in conformity with the rim (130; 1130),
a circumference of the case having the groove (430; 1430) has double circumferences with an inner circumference (432; 1432) positioned on an inner side of the groove (430; 1430) and an outer circumference (431; 1431) positioned on an outer side of the groove, and
the inner circumference (432; 1432) has a projection length longer than a projection length of the outer circumference (431; 1431),
**characterized in that**
one of the upper case (400; 1400) and the lower case (100; 1100) includes hooks (133; 1133) and the other one includes hook holes (433; 1433) in conformity with the hooks (133; 1133),
the control board includes:
a communication modem board (200; 1200) for transmission/reception of data to/from the home appliance, and
a display board (300; 1300) mounted on the communication modem board (200; 1200) fixedly, or detachably for displaying a state of the state of the home appliance to an outside,
the display board (300; 1300) is exposed through the window (410; 1410), and
the remote monitor (1; 10) further comprises a see-through sheet (600; 1600) on an upper surface of the upper case (400; 1400), which is an exposed surface, for see-through an inside through the window, and a protective sheet (700; 1700) on an upper surface of the see-through sheet having a see-through window (710; 1710) in correspondence to the window (410; 1410) on the upper case (400; 1400).

2. The remote monitor (1; 10) as claimed in claim 1, wherein one of the communication modem board (200; 1200) or the display board (300; 1300) includes male terminal pins (310; 1310), and the other one includes female terminal pins (210; 1210) opposite to the male terminal pins for placing in the female terminal pins.

3. The remote monitor (1; 10) as claimed in claim 1, further comprising at least one supporting pin (182; 1182) passed through the communication modem board (200; 1200) and supporting the display board (300; 1300).

4. The remote monitor (1; 10) as claimed in claim 1, wherein the display board (300; 1300) includes:
an LCD segment (320; 1320) fastened thereto with screws, or hooks for display of state information, such as a progress of operation and cycle error of the home appliance, to an outside with numerals or characters.

5. The remote monitor (1; 10) as claimed in claim 1, wherein the communication system is a power line communication system for transmission/reception of data through a power line.

6. The remote monitor (1; 10) as claimed in claim 1, wherein the upper case (400; 1400) includes fastening bosses projected downward, and the lower case (100; 1100) includes fastening holes in correspondence to the fastening bosses, wherein the upper case (400; 1400) and the lower case (100; 1100) are coupled at a time as fastening members are fastened to the fastening bosses through the fastening holes, respectively.

7. The remote monitor (1; 10) as claimed in claim 6, wherein the fastening bosses are formed at corners of a lower surface of the upper case (400; 1400), which is an unexposed surface.

8. The remote monitor (1; 10) as claimed in claim 6, wherein the fastening member is a fastening screw to be fastened to the fastening boss as the fastening screw is fastened to a hole in the fastening boss while forming a thread.

9. The remote monitor (1; 10) as claimed in claim 6, wherein the upper case (400; 1400) includes a shrinkage preventive groove for preventing the fastening boss from shrinking at the time of injection molding with a mold.

10. The remote monitor (1; 10) as claimed in claim 9, wherein the shrinkage preventive grooves are formed in the upper surface which is an exposed surface of the upper case (400; 1400), each in a shape of a ring in correspondence to the fastening bosses.

11. The remote monitor (1; 10) as claimed in claim 1, wherein the see-through sheet (600; 1600) and the protective sheet (700; 1700) have sizes in correspondence to the upper surface of the upper case (400; 1400), respectively.

12. The remote monitor (1; 10) as claimed in claim 1, wherein the see-through sheet (600; 1600) is provided to be placed on the upper surface of the upper case (400; 1400), with a size corresponding to a size of the window on the upper case (400; 1400), and the protective sheet (700; 1700) has a size in correspondence to the upper surface of the upper case (400; 1400).

13. The remote monitor (1; 10) as claimed in claim 1, wherein the see-through sheet (600; 1600) is formed of PET (polyethylene terephthalate).

14. The remote monitor (1; 10) as claimed in claim 1, wherein the protective sheet (700; 1700) is formed of a light metal, such as aluminum.

15. The remote monitor (1; 10) as claimed in claim 1, wherein the upper case (400; 1400) includes an interference preventive groove (402; 1402) in the upper surface of the upper case (400; 1400) for preventing interference of burrs left at an edge of the protective sheet (700; 1700).

16. The remote monitor (1; 10) as claimed in claim 1, wherein the upper case (400; 1400) includes a button hole (470; 1470), with an operation button (800; 1800) provided therein for being brought into contact with a switch (370; 1370) on the control board as the operation button (800; 1800) is pressed, and returning to an original position after being pressed.

17. The remote monitor (1; 10) as claimed in claim 16, wherein the operation button (800; 1800) includes;
a pressing portion (810; 1810) passed through the button hole and exposed to an outside of the upper surface of the upper case (400; 1400), and
a mounting portion (820; 1820) formed as one body with the pressing portion at a lower portion for being held at an underside of the upper case (400; 1400) around the button hole (470; 1470).

18. The remote monitor (1; 10) as claimed in claim 17, wherein the mounting portion (820; 1820) includes elastic ribs (822; 1822) of a plurality of slots for providing restoring force to the operation button (800; 1800).

19. The remote monitor (1; 10) as claimed in claim 17, wherein the mounting portion includes a contact projection on an underside to be in contact with a switch on the control board.

20. The remote monitor (1; 10) as claimed in claim 17, wherein the mounting portion (820; 1820) is hooked to hooks on an underside of the upper case (400; 1400).

21. The remote monitor (1; 10) as claimed in claim 17, wherein the mounting portion (820; 1820) includes an interference avoidance slot (823; 1823) at a circumference for preventing the operation button (800; 1800) from interfering with an electronic component on the control board.

22. The remote monitor (1; 10) as claimed in claim 21, wherein the interference avoidance slot (823; 1823) is formed at a portion of the circumference where the mounting portion (820; 1820) interferes with the electronic component on the control board on both sides of the circumference symmetrically.

23. The remote monitor (1; 10) as claimed in claim 16, wherein the upper case (400; 1400) includes a downward stepped portion (473; 1473) around the button hole (470; 1470), and the mounting portion (820; 1820) of the operation button (800; 1800) includes a counter stepped portion (824; 1824) projected opposite to the stepped portion such that the counter stepped portion is in close contact with an underside of the upper case (400; 1400).

24. The remote monitor (1; 10) as claimed in claim 23, wherein the stepped portion (473; 1473) and the counter stepped portion (824; 1824) have identical lengths.

25. The remote monitor (1; 10) as claimed in claim 1, wherein the rim (130; 1130) and groove (430; 1430) are formed along, and throughout opposite upper and lower circumferences.

26. The remote monitor (1; 10) as claimed in claim 1, wherein the groove (430; 1430) includes a sealing portion where edges of an end of the rim (130; 1130) are pressed down thereon when the groove (430; 1430) is engaged with the projection.

27. The remote monitor (1; 10) as claimed in claim 26, wherein the sealing portion is sloped surfaces which are to be pressed down by the edges of the rim (130; 1130).

28. The remote monitor (1; 10) as claimed in claim 1, wherein the lower case (100; 1100) includes slide portions (430a; 1430a) at the upper surface which is an unexposed surface of the lower case (100; 1100), for removing a mold without interference with the hooks (133; 1133) at the time of injection molding of the lower case with the mold.

29. The remote monitor (1; 10) as claimed in claim 28, wherein the slide portion (430a; 1430a) is a flat portion extended from an edge of the upper surface of the lower case (100; 1100) to a circumference of the lower case (100; 1100) under the hook (133; 1133).

30. The remote monitor (1; 10) as claimed in claim 1, wherein the lower case (100; 1100) includes guide ribs (170; 1170) for placing the control board at a position spaced a predetermined height from the upper surface of the lower case (100; 1100), and preventing the control board from shaking.

31. The remote monitor (1; 10) as claimed in claim 29, wherein the guide rib (170; 1170) has an "L" shaped substantially.

32. The remote monitor (1; 10) as claimed in claim 1, wherein the upper case (400; 1400) includes at least one upper supporting boss projected therefrom for supporting the control board.

33. The remote monitor (1; 10) as claimed in claim 1, wherein the lower case (100; 1100) includes at least one lower supporting boss (181; 1181) projected therefrom for supporting the control board.

34. The remote monitor (1; 10) as claimed in claim 1, further comprising securing means for securing the case to a wall at a place far from the home appliance.

35. The remote monitor (1; 10) as claimed in claim 34, wherein the securing means includes;
a mounting portion (190; 1190) projected outward from a bottom of the lower case (100; 1100) which is an exposed side of the lower case (100; 1100), and
a hanger (900; 1900) to be fixedly secured to the wall far from the home appliance for placing the mounting portion thereon.

36. The remote monitor (1; 10) as claimed in claim 35, wherein one of the mounting portion (190; 1190) and the hanger (900; 1900) includes guide projections (191; 1191), and the other one includes a seating portion (910; 1910) having guide grooves for slidably placing the guide projections therein, respectively.

37. The remote monitor (1; 10) as claimed in claim 35, wherein the hanger (900; 1900) has a size smaller than a size of the lower case (100; 1100).

38. The remote monitor (1; 10) as claimed in claim 1, further comprising a speaker for announcing a state of progress of the home appliance with a designated sound.

39. The remote monitor (1; 10) as claimed in claim 1, wherein the case further comprises:
an outer case (500) detachably mounted on an upper side of the upper case, the outer case having a display window (510) in correspondence to the window.

40. The remote monitor (1; 10) as claimed in claim 39, further comprising a see-through sheet on an upper surface of the outer case (500), which is an exposed surface, for see-through an inside through the display window, and a protective sheet on an upper surface of the see-through sheet having a see-through window in correspondence to the display window on the outer case.

41. The remote monitor (1; 10) as claimed in claim 40, wherein the see-through sheet and the protective sheet (700; 1700) have sizes in correspondence to the upper surface of the upper case (400; 1400), respectively.

42. The remote monitor (1; 10) as claimed in claim 40, wherein the see-through sheet is provided to be placed on the upper surface of the outer case (500), with a size corresponding to a size of the display window on the outer case, and the protective sheet (700; 1700) has a size in correspondence to the upper surface of the outer case.

43. The remote monitor (1; 10) as claimed in claim 40, wherein the see-through sheet is formed of PET (polyethylene terephthalate).

44. The remote monitor (1; 10) as claimed in claim 40, wherein the protective sheet (700; 1700) is formed of a light metal, such as aluminum.

45. The remote monitor (1; 10) as claimed in claim 40, wherein the outer case (500) includes an interference preventive groove (502) in the upper surface of the outer case for preventing interference of burrs left at an edge of the protective sheet (700; 1700).

## Patentansprüche

1. Fernüberwachungsvorrichtung (1; 10) für eine Heimanwendung, wobei die Fernüberwachungsvorrichtung (1; 10) zum Anzeigen und Steuern eines Zustands der Heimanwendung an einem von der Heimanwendung entfernten Ort mit mindestens einer Heimanwendung mit einem vorgegebenen Kommunikationssystem verbunden ist, die Folgendes umfasst:
ein Gehäuse, das ein äußeres Erscheinungsbild der Fernüberwachungsvorrichtung (1; 10) bildet, das ein unteres Gehäuse (100; 1100) und ein oberes Gehäuse (400; 1400), das auf einer Oberseite des unteren Gehäuses (100; 1100) abnehmbar angebracht ist, enthält, wobei das obere Gehäuse (400; 1400) ein Fenster (410; 1410) aufweist; und
eine Steuerleiterplatte im Gehäuse, wobei die Steuerleiterplatte diverse darauf angebrachte elektronische Komponenten aufweist,
wobei entweder das obere Gehäuse (400; 1400) oder das untere Gehäuse (100; 1100) einen Rand (130; 1130) enthält und das andere Gehäuse eine Rille (430; 1430) in Übereinstimmung mit dem Rand (130; 1130) enthält,
ein Umfang des Gehäuses, das die Rille (430; 1430) aufweist, einen doppelten Umfang aufweist, wobei ein Innenumfang (432, 1432) auf einer Innenseite der Rille (430; 1430) angeordnet ist und ein Außenumfang (431; 1431) auf einer Außenseite der Rille angeordnet ist, und
der Innenumfang (432; 1432) eine Projektionslänge aufweist, die länger als eine Projektionslänge des Außenumfangs (431; 1431) ist,
**dadurch gekennzeichnet, dass**
entweder das obere Gehäuse (400, 1400) oder das untere Gehäuse (100; 1100) Haken (133; 1133) enthält und das andere Gehäuse Hakenlöcher (433, 1433) in Übereinstimmung mit den Haken (133; 1133) enthält,
die Steuerleiterplatte Folgendes enthält:
eine Kommunikationsmodemleiterplatte (200; 1200) zum Senden/Empfangen von Daten zu/von der Heimanwendung, und
eine Anzeigeleiterplatte (300; 1300), die zum Anzeigen eines Zustands des Zustands der Heimanwendung auf eine Außenseite auf der Kommunikationsmodemleiterplatte (200; 1200) feststehend oder abnehmbar angebracht ist,
die Anzeigeleiterplatte (300; 1300) durch das Fenster (410; 1410) freiliegt und die Fernüberwachungsvorrichtung (1; 10) ferner zum Durchsehen auf eine Innenseite durch das Fenster auf einer oberen Fläche des oberen Gehäuses (400; 1400), die eine freiliegende Fläche ist, eine durchsichtige Folie (600; 1600) und auf einer oberen Fläche der durchsichtigen Folie eine Schutzfolie (700; 1700), die ein durchsichtiges Fenster (710; 1710) in Übereinstimmung mit dem Fenster (410; 1410) auf dem oberen Gehäuse (400; 1400) aufweist, umfasst.

2. Fernüberwachungsvorrichtung (1; 10) nach Anspruch 1, wobei entweder die Kommunikationsmodemleiterplatte (200; 1200) oder die Anzeigeleiterplatte (300; 1300) Steckeranschlussstifte (310; 1310) enthält und die andere Leiterplatte Buchsenanschlussstifte (210; 1210) enthält, die zum Anordnen der Steckeranschlussstifte in den Buchsenanschlussstiften gegenüber den Steckeranschlussstiften angeordnet sind.

3. Fernüberwachungsvorrichtung (1; 10) nach Anspruch 1, die mindestens einen Tragstift (182; 1182) umfasst, der durch die Kommunikationsmodemleiterplatte (200; 1200) verläuft und die Anzeigeleiterplatte (300; 1300) trägt.

4. Fernüberwachungsvorrichtung (1; 10) nach Anspruch 1, wobei die Anzeigeleiterplatte (300; 1300) Folgendes enthält:
ein LCD-Segment (320; 1320), das zum Anzeigen von Zustandsinformationen, wie etwa ein Betriebsfortschritt und ein Zyklusfehler der Heimanwendung, mit Zahlen oder Buchstaben auf eine Außenseite mit Schrauben oder Haken daran befestigt ist.

5. Fernüberwachungsvorrichtung (1; 10) nach Anspruch 1, wobei das Kommunikationssystem ein Stromleitungskommunikationssystem zum Senden/Empfangen von Daten durch eine Stromleitung ist.

6. Fernüberwachungsvorrichtung (1; 10) nach Anspruch 1, wobei das obere Gehäuse (400; 1400) Befestigungserhebungen enthält, die nach unten vorstehen, und das untere Gehäuse (100; 1100) Befestigungslöcher in Übereinstimmung mit den Befestigungserhebungen enthält, wobei das obere Gehäuse (400; 1400) und das untere Gehäuse (100; 1100) jeweils gekoppelt werden, während durch die Befestigungslöcher jeweils Befestigungselemente an den Befestigungserhebungen befestigt werden.

7. Fernüberwachungsvorrichtung (1; 10) nach Anspruch 6, wobei die Befestigungserhebungen an den Ecken einer unteren Fläche des oberen Gehäuses (400; 1400) gebildet sind, die eine nicht freiliegende Fläche ist.

8. Fernüberwachungsvorrichtung (1; 10) nach Anspruch 6, wobei das Befestigungselement eine Befestigungsschraube ist, die an der Befestigungserhebung zu befestigen ist, indem die Befestigungsschraube an einem Loch in der Befestigungserhebung befestigt wird, während sie ein Gewinde bildet.

9. Fernüberwachungsvorrichtung (1; 10) nach Anspruch 6, wobei das obere Gehäuse (400; 1400) zum Verhindern, dass die Befestigungserhebung zur Zeit des Formgießens mit einer Form schwindet, eine Schwundverhinderungsfuge enthält.

10. Fernüberwachungsvorrichtung (1; 10) nach Anspruch 9, wobei die Schwundverhinderungsfugen in der oberen Fläche, die ein freiliegende Fläche des oberen Gehäuses (400; 1400) ist, jeweils in Form eines Rings in Übereinstimmung mit der Befestigungserhebung ausgebildet sind.

11. Fernüberwachungsvorrichtung (1; 10) nach Anspruch 1, wobei die durchsichtige Folie (600; 1600) und die Schutzfolie (700; 1700) jeweils Größen in Übereinstimmung mit der oberen Fläche des oberen Gehäuses (400; 1400) aufweisen.

12. Fernüberwachungsvorrichtung (1; 10) nach Anspruch 1, wobei die durchsichtige Folie (600; 1600) derart vorgesehen ist, dass sie auf der oberen Fläche des oberen Gehäuses (400; 1400) angeordnet ist, wobei eine Größe einer Größe des Fensters auf dem oberen Gehäuse (400; 1400) entspricht und die Schutzfolie (700; 1700) eine Größe in Übereinstimmung mit der oberen Fläche des oberen Gehäuses (400; 1400) aufweist.

13. Fernüberwachungsvorrichtung (1; 10) nach Anspruch 1, wobei die durchsichtige Folie (600; 1600) aus PET (Polyethylenterephthalat) gebildet ist.

14. Fernüberwachungsvorrichtung (1; 10) nach Anspruch 1, wobei die Schutzfolie (700; 1700) aus einem leichten Metall, wie etwa Aluminium, gebildet ist.

15. Fernüberwachungsvorrichtung (1; 10) nach Anspruch 1, wobei das obere Gehäuse (400; 1400) zum Verhindern einer Überlagerung mit Graten, die an einer Kante der Schutzfolie (700; 1700) verblieben sind, in der oberen Fläche des oberen Gehäuses (400; 1400) eine Überlagerungsverhinderungsfuge (402; 1402) enthält.

16. Fernüberwachungsvorrichtung (1; 10) nach Anspruch 1, wobei das obere Gehäuse (400; 1400) ein Knopfloch (470; 1470) enthält, wobei darin ein Bedienknopf (800; 1800) derart vorgesehen ist, dass er mit einem Schalter (370; 1370) auf der Steuerleiterplatte in Kontakt gebracht wird, während der Bedienknopf (800; 1800) gedrückt wird, und in eine Ursprungsposition zurückkehrt, nachdem er gedrückt wurde.

17. Fernüberwachungsvorrichtung (1; 10) nach Anspruch 16, wobei der Bedienknopf (800; 1800) Folgendes enthält:
einen Drückabschnitt (810; 1810), der durch das Knopfloch verläuft und zu einer Außenseite der oberen Fläche des oberen Gehäuses (400; 1400) freiliegt, und
einen Montageabschnitt (820; 1820), der mit dem Drückabschnitt als ein Körper an einem unteren Abschnitt derart ausgebildet ist, dass er an einer Unterseite des oberen Gehäuses (400; 1400) um das Knopfloch (470; 1470) gehalten wird.

18. Fernüberwachungsvorrichtung (1; 10) nach Anspruch 17, wobei der Montageabschnitt (820; 1820) zum Bereitstellen einer Rückstellkraft auf den Bedienknopf (800; 1800) elastische Rippen (822; 1822) mehrerer Schlitze enthält.

19. Fernüberwachungsvorrichtung (1; 10) nach Anspruch 17, wobei der Montageabschnitt auf einer Unterseite einen Kontaktvorsprung enthält, um sich mit einem Schalter auf der Steuerleiterplatte in Kontakt zu befinden.

20. Fernüberwachungsvorrichtung (1; 10) nach Anspruch 17, wobei der Montageabschnitt (820; 1820) zu den Haken auf einer Unterseite des oberen Gehäuses (400; 1400) hakenförmig ist.

21. Fernüberwachungsvorrichtung (1; 10) nach Anspruch 17, wobei der Montageabschnitt (820; 1820) zum Verhindern, dass der Bedienknopf (800; 1800) eine elektronischen Komponente auf der Steuerleiterplatte überlagert, einen Überlagerungsvermeidungsschlitz (823; 1823) enthält.

22. Fernüberwachungsvorrichtung (1; 10) nach Anspruch 21, wobei der Überlagerungsvermeidungsschlitz (823; 1823) an einem Abschnitt des Umfangs, an dem der Montageabschnitt (820; 1820) die elektronischen Komponente auf der Steuerleiterplatte überlagert, auf beiden Seiten des Umfangs symmetrisch ausgebildet ist.

23. Fernüberwachungsvorrichtung (1; 10) nach Anspruch 16, wobei das obere Gehäuse (400; 1400) um das Knopfloch (470; 1470) einen nach unten abgestuften Abschnitt (473; 1473) enthält und der Montageabschnitt (820; 1820) des Bedienknopfs (800; 1800) einen entgegengesetzt abgestuften Abschnitt (824, 1824) enthält, der gegenüber dem abgestuften Abschnitt derart vorsteht, dass sich der entgegengesetzt abgestufte Abschnitt in engem Kontakt mit einer Unterseite des oberen Gehäuses (400; 1400) befindet.

24. Fernüberwachungsvorrichtung (1; 10) nach Anspruch 23, wobei der abgestufte Abschnitt (473; 1473) und der entgegengesetzt abgestufte Abschnitt (824; 1824) identische Längen aufweisen.

25. Fernüberwachungsvorrichtung (1; 10) nach Anspruch 1, wobei der Rand (130; 1130) und die Rille (430; 1430) entlang des und durchgehend am gegenüberliegenden oberen und unteren Umfang gebildet sind.

26. Fernüberwachungsvorrichtung (1; 10) nach Anspruch 1, wobei die Rille (430; 1430) einen Dichtungsabschnitt enthält, wobei die Kanten eines Endes des Randes (130; 1130) darauf gedrückt werden, wenn sich die Rille (430; 1430) mit dem Vorsprung in Eingriff befindet.

27. Fernüberwachungsvorrichtung (1; 10) nach Anspruch 26, wobei der Dichtungsabschnitt aus geneigten Flächen besteht, die durch die Kanten des Randes (130; 1130) herunterzudrücken sind.

28. Fernüberwachungsvorrichtung (1; 10) nach Anspruch 1, wobei das untere Gehäuse (100; 1100) zum Entfernen einer Gießform ohne Überlagerung mit den Haken (133; 1133) zur Zeit des Spritzgießens des unteren Gehäuses mit der Gießform an der oberen Fläche, die eine nicht freiliegende Fläche des unteren Gehäuses (100; 1100) ist, Gleitabschnitte (430a; 1430a) enthält.

29. Fernüberwachungsvorrichtung (1; 10) nach Anspruch 28, wobei der Gleitabschnitt (430a; 1430a) ein flacher Abschnitt ist, der sich von einer Kante der oberen Fläche des unteren Gehäuses (100; 1100) zu einem Umfang des unteren Gehäuses (100; 1100) unter dem Haken (133; 1133) erstreckt.

30. Fernüberwachungsvorrichtung (1; 10) nach Anspruch 1, wobei das untere Gehäuse (100; 1100) zum Anordnen der Steuerleiterplatte an einer Position, die um eine vorgegebene Höhe von der oberen Fläche des unteren Gehäuses (100; 1100) beabstandet ist, und zum Verhindern, dass die Steuerleiterplatte wackelt, Führungsrippen (170; 1170) enthält.

31. Fernüberwachungsvorrichtung (1; 10) nach Anspruch 29, wobei die Führungsrippe (170; 1170) im Wesentlichen eine "L"-Form aufweist.

32. Fernüberwachungsvorrichtung (1; 10) nach Anspruch 1, wobei das obere Gehäuse (400; 1400) mindestens eine obere Tragerhebung enthält, die zum Tragen der Steuerleiterplatte davon vorsteht.

33. Fernüberwachungsvorrichtung (1; 10) nach Anspruch 1, wobei das untere Gehäuse (100; 1100) mindestens eine untere Tragerhebung (181; 1181) enthält, die zum Tragen der Steuerleiterplatte davon vorsteht.

34. Fernüberwachungsvorrichtung (1; 10) nach Anspruch 1, die ferner Befestigungsmittel zum Befestigen des Gehäuses an einer Wand an einem von der Heimanwendung entfernten Ort umfasst.

35. Fernüberwachungsvorrichtung (1; 10) nach Anspruch 34, wobei die Befestigungsmittel Folgendes enthalten:
einen Montageabschnitt (190; 1190), der von einem Boden des unteren Gehäuses (100; 1100), der eine freiliegende Seite des unteren Gehäuses (100; 1100) ist, nach außen vorsteht, und
einen Aufhänger (900; 1900), der zum Anordnen des Montageabschnitts darauf an der von der Heimanwendung entfernten Wand feststehend zu befestigen ist.

36. Fernüberwachungsvorrichtung (1; 10) nach Anspruch 35, wobei entweder der Montageabschnitt (190; 1190) oder der Aufhänger (900; 1900) Führungsvorsprünge (191; 1191) enthält und die andere Komponente einen Sitzabschnitt (910; 1910) enthält, der Führungsfugen jeweils zum gleitenden Anordnen der Führungsvorsprünge darin aufweist.

37. Fernüberwachungsvorrichtung (1; 10) nach Anspruch 35, wobei der Aufhänger (900; 1900) eine Größe aufweist, die kleiner als eine Größe des unteren Gehäuses (100; 1100) ist.

38. Fernüberwachungsvorrichtung (1; 10) nach Anspruch 1, die ferner einen Lautsprecher zum Anzeigen eines Fortschrittszustands der Heimanwendung mit einem zugewiesenen Ton umfasst.

39. Fernüberwachungsvorrichtung (1; 10) nach Anspruch 1, wobei das Gehäuse ferner Folgendes umfasst:
ein Außengehäuse (500), das an einer Oberseite des oberen Gehäuses abnehmbar angebracht ist, wobei das Außengehäuse ein Anzeigefenster (510) in Übereinstimmung mit dem Fenster aufweist.

40. Fernüberwachungsvorrichtung (1; 10) nach Anspruch 39, die ferner zum Durchsehen auf eine Innenseite durch das Anzeigefenster auf einer oberen Fläche des Außengehäuses (500), die eine freiliegende Fläche ist, eine durchsichtige Folie und auf einer oberen Fläche der durchsichtigen Folie eine Schutzfolie, die ein durchsichtiges Fenster in Übereinstimmung mit dem Anzeigefenster auf dem Außengehäuse aufweist, umfasst.

41. Fernüberwachungsvorrichtung (1; 10) nach Anspruch 40, wobei die durchsichtige Folie und die Schutzfolie (700; 1700) jeweils Größen in Übereinstimmung mit der oberen Fläche des oberen Gehäuses (400; 1400) aufweisen.

42. Fernüberwachungsvorrichtung (1; 10) nach Anspruch 40, wobei die durchsichtige Folie derart vorgesehen ist, dass sie auf der oberen Fläche des Außengehäuses (500) angeordnet ist, wobei eine Größe einer Größe des Anzeigefensters auf dem Außengehäuse entspricht und die Schutzfolie (700; 1700) eine Größe in Übereinstimmung mit der oberen Fläche des Außengehäuses aufweist.

43. Fernüberwachungsvorrichtung (1; 10) nach Anspruch 40, wobei die durchsichtige Folie aus PET (Polyethylenterephthalat) gebildet ist.

44. Fernüberwachungsvorrichtung (1; 10) nach Anspruch 40, wobei die Schutzfolie (700; 1700) aus einem leichten Metall, wie etwa Aluminium, gebildet ist.

45. Fernüberwachungsvorrichtung (1; 10) nach Anspruch 40, wobei das Außengehäuse (500) zum Verhindern einer Überlagerung mit Graten, die an einer Kante der Schutzfolie (700; 1700) verblieben sind, in der oberen Fläche des Außengehäuses eine Überlagerungsverhinderungsfuge (502) enthält.

## Revendications

1. Dispositif de télésurveillance (1 ; 10) pour un appareil domestique, le dispositif de télésurveillance (1 ; 10) étant raccordé à au moins un appareil domestique avec un système de communication prédéterminé pour afficher et commander un état de l'appareil domestique à un lieu éloigné de l'appareil domestique, comprenant :
un boîtier constituant une apparence extérieure du dispositif de télésurveillance (1 ; 10), comprenant un boîtier inférieur (100 ; 1100) et un boîtier supérieur (400 ; 1400) monté, de manière détachable, sur un côté supérieur du boîtier inférieur (100 ; 1100), le boîtier supérieur (400 ; 1400) comportant une fenêtre (410 ; 1410) ; et
une carte de commande dans le boîtier, la carte de commande comportant divers composants électroniques montés sur celle-ci,
dans lequel l'un du boîtier supérieur (400 ; 1400) et du boîtier inférieur (100 ; 1100) comprend un rebord (130 ; 1130), et l'autre comprend une rainure (430 ; 1430) conforme au rebord (130 ; 1130),
une circonférence du boîtier comportant la rainure (430 ; 1430) présente deux circonférences avec une circonférence intérieure (432 ; 1432) positionnée sur un côté intérieur de la rainure (430 ; 1430) et une circonférence extérieure (431 ; 1431) positionnée sur un côté extérieur de la rainure, et
la circonférence intérieure (432 ; 1432) a une longueur de saillie supérieure à une longueur de saillie de la circonférence extérieure (431 ; 1431),
**caractérisé en ce que**
l'un du boîtier supérieur (400 ; 1400) et du boîtier inférieur (100 ; 1100) comprend des crochets (133 ; 1133) et l'autre comprend des trous de crochets (433 ; 1433) conformes aux crochets (133 ; 1133),
la carte de commande comprend :
une carte de modem de communication (200 ; 1200) pour une transmission/réception de données à destination/en provenance de l'appareil domestique, et
une carte d'affichage (300 ; 1300) montée sur la carte de modem de communication (200 ; 1200), de manière fixe ou détachable, pour afficher un état de l'appareil domestique à un extérieur,
la carte d'affichage (300 ; 1300) est exposée à travers la fenêtre (410 ; 1410), et le dispositif de télésurveillance (1 ; 10) comprend en outre une feuille transparente (600 ; 1600) sur une surface supérieure du boîtier supérieur (400 ; 1400), qui est une surface exposée, pour voir un intérieur à travers la fenêtre, et une feuille protectrice (700 ; 1700) sur une surface supérieure de la feuille transparente ayant une fenêtre transparente (710 ; 1710) correspondant à la fenêtre (410 ; 1410) sur le boîtier supérieur (400 ; 1400).

2. Dispositif de télésurveillance (1 ; 10) selon la revendication 1, dans lequel l'une de la carte de modem de communication (200 ; 1200) ou de la carte d'affichage (300 ; 1300) comprend des broches de borne mâle (310 ; 1310), et l'autre comprend des broches de borne femelle (210 ; 1210) à l'opposé des broches de borne mâle pour un placement dans les broches de borne femelle.

3. Dispositif de télésurveillance (1 ; 10) selon la revendication 1, comprenant en outre au moins une broche de support (182 ; 1182) passée à travers la carte de modem de communication (200 ; 1200) et supportant la carte d'affichage (300 ; 1300).

4. Dispositif de télésurveillance (1 ; 10) selon la revendication 1, dans lequel la carte d'affichage (300 ; 1300) comprend :
un segment LCD (320 ; 1320) fixée à celle-ci avec des vis ou des crochets pour l'affichage d'informations d'état, comme un déroulement d'une opération et une erreur de cycle de l'appareil domestique, à un extérieur avec des chiffres ou des caractères.

5. Dispositif de télésurveillance (1 ; 10) selon la revendication 1, dans lequel le système de communication est un système de communication par ligne électrique pour une transmission/réception de données par l'intermédiaire d'une ligne électrique.

6. Dispositif de télésurveillance (1 ; 10) selon la revendication 1, dans lequel le boîtier supérieur (400 ; 1400) comprend des bossages de fixation faisant saillie vers le bas, et le boîtier inférieur (100 ; 1100) comprend des trous de fixation correspondant aux bossages de fixation, dans lequel le boîtier supérieur (400 ; 1400) et le boîtier inférieur (100 ; 1100) sont couplés à un temps auquel des organes de fixation sont fixés aux bossages de fixation respectivement par l'intermédiaire des trous de fixation.

7. Dispositif de télésurveillance (1 ; 10) selon la revendication 6, dans lequel les bossages de fixation sont formés à des coins d'une surface inférieure du boîtier supérieur (400 ; 1400), qui est une surface non exposée.

8. Dispositif de télésurveillance (1 ; 10) selon la revendication 6, dans lequel l'organe de fixation est une vis de fixation à fixer au bossage de fixation lorsque la vis de fixation est fixée à un trou dans le bossage de fixation tout en formant un filetage.

9. Dispositif de télésurveillance (1 ; 10) selon la revendication 6, dans lequel le boîtier supérieur (400 ; 1400) comprend une rainure anti-rétrécissement pour empêcher le rétrécissement du bossage de fixation lors d'un moulage par injection avec un moule.

10. Dispositif de télésurveillance (1 ; 10) selon la revendication 9, dans lequel les rainures anti-rétrécissement sont formées dans la surface supérieure qui est une surface exposée du boîtier supérieur (400 ; 1400), chacune ayant une forme annulaire conforme aux bossages de fixation.

11. Dispositif de télésurveillance (1 ; 10) selon la revendication 1, dans lequel la feuille transparente (600 ; 1600) et la feuille protectrice (700 ; 1700) ont des formes correspondant respectivement à la surface supérieure du boîtier supérieur (400 ; 1400).

12. Dispositif de télésurveillance (1 ; 10) selon la revendication 1, dans lequel la feuille transparente (600 ; 1600) est prévue pour être placée sur la surface supérieure du boîtier supérieur (400 ; 1400), avec une taille correspondant à une taille de la fenêtre sur le boîtier supérieur (400 ; 1400), et la feuille protectrice (700 ; 1700) a une taille correspondant à la surface supérieure du boîtier supérieur (400 ; 1400).

13. Dispositif de télésurveillance (1 ; 10) selon la revendication 1, dans lequel la feuille transparente (600 ; 1600) est constituée de polyéthylène téréphtalate (PET).

14. Dispositif de télésurveillance (1 ; 10) selon la revendication 1, dans lequel la feuille protectrice (700 ; 1700) est constituée d'un métal léger, comme de l'aluminium.

15. Dispositif de télésurveillance (1 ; 10) selon la revendication 1, dans lequel le boîtier supérieur (400 ; 1400) comprend une rainure anti-interférence (402 ; 1402) dans la surface supérieure du boîtier supérieur (400 ; 1400) pour empêcher toute interférence de bavures laissées à un bord de la feuille protectrice (700 ; 1700).

16. Dispositif de télésurveillance (1 ; 10) selon la revendication 1, dans lequel le boîtier supérieur (400 ; 1400) comprend un trou de bouton (470 ; 1470), avec un bouton de fonctionnement (800 ; 1800) prévu à l'intérieur de celui-ci pour être mis en contact avec un commutateur (370 ; 1370) sur la carte de commande lorsque le bouton de fonctionnement (800 ; 1800) est pressé et pour revenir à une position initiale après avoir été pressé.

17. Dispositif de télésurveillance (1 ; 10) selon la revendication 16, dans lequel le bouton de fonctionnement (800 ; 1800) comprend :
une portion de pression (810 ; 1810) passée à travers le trou de bouton et exposée à un extérieur de la surface supérieure du boîtier supérieur (400 ; 1400), et
une portion de montage (820 ; 1820) formée sous la forme d'un corps avec la portion de pression à une portion inférieure pour être maintenue à un dessous du boîtier supérieur (400 ; 1400) autour du trou de bouton (470 ; 1470).

18. Dispositif de télésurveillance (1 ; 10) selon la revendication 17, dans lequel la portion de montage (820 ; 1820) comprend des nervures élastique (822 ; 1822) d'une pluralité de fentes pour fournir une force de rétablissement au bouton de fonctionnement (800 ; 1800).

19. Dispositif de télésurveillance (1 ; 10) selon la revendication 17, dans lequel la portion de montage comprend une saillie de contact sur un dessous pour être en contact avec un commutateur sur la carte de commande.

20. Dispositif de télésurveillance (1 ; 10) selon la revendication 17, dans lequel la portion de montage (820 ; 1820) est accrochée à des crochets sur un dessous du boîtier supérieur (400 ; 1400).

21. Dispositif de télésurveillance (1 ; 10) selon la revendication 17, dans lequel la portion de montage (820 ; 1820) comprend une fente anti-interférence (823 ; 1823) à une circonférence pour empêcher toute interférence du bouton de fonctionnement (800 ; 1800) avec un composant électronique sur la carte de commande.

22. Dispositif de télésurveillance (1 ; 10) selon la revendication 21, dans lequel la fente anti-interférence (823 ; 1823) est formée à une portion de la circonférence à laquelle la portion de montage (820 ; 1820) est en interférence avec le composant électronique sur la carte de commande symétriquement des deux côtés de la circonférence.

23. Dispositif de télésurveillance (1 ; 10) selon la revendication 16, dans lequel le boîtier supérieur (400 ; 1400) comprend une portion échelonnée vers le bas (473 ; 1473) autour du trou de bouton (470 ; 1470), et la portion de montage (820 ; 1820) du bouton de fonctionnement (800 ; 1800) comprend une contre-portion échelonnée (824 ; 1824) faisant saillie à l'opposé de la portion échelonnée de sorte que la contre-portion échelonnée soit en contact étroit avec un dessous du boîtier supérieur (400 ; 1400).

24. Dispositif de télésurveillance (1 ; 10) selon la revendication 23, dans lequel la portion échelonnée (473 ; 1473) et la contre-portion échelonnée (824 ; 1824) ont des longueurs identiques.

25. Dispositif de télésurveillance (1 ; 10) selon la revendication 1, dans lequel le rebord (130 ; 1130) et la rainure (430 ; 1430) sont formés le long de circonférences supérieure et inférieure opposées et à travers celles-ci.

26. Dispositif de télésurveillance (1 ; 10) selon la revendication 1, dans lequel la rainure (430 ; 1430) comprend une portion d'étanchéité où des bords d'une extrémité du rebord (130 ; 1130) sont pressés vers le bas sur celle-ci lorsque la rainure (430 ; 1430) est mise en prise avec la saillie.

27. Dispositif de télésurveillance (1 ; 10) selon la revendication 26, dans lequel la portion d'étanchéité est constituée de surfaces inclinées qui doivent être pressées vers le bas par les bords du rebord (130 ; 1130).

28. Dispositif de télésurveillance (1 ; 10) selon la revendication 1, dans lequel le boîtier inférieur (100 ; 1100) comprend des portions coulissantes (430a, 1430a) à la surface supérieure qui est une surface non exposée du boîtier inférieur (100 ; 1100), pour enlever un moule sans interférence avec les crochets (133 ; 1133) au moment d'un moulage par injection du boîtier inférieur avec le moule.

29. Dispositif de télésurveillance (1 ; 10) selon la revendication 28, dans lequel la portion coulissante (430a ; 1430a) est une portion plate s'étendant d'un bord de la surface supérieure du boîtier inférieur (100 ; 1100) jusqu'à une circonférence du boîtier inférieur (100 ; 1100) sous le crochet (133 ; 1133).

30. Dispositif de télésurveillance (1 ; 10) selon la revendication 1, dans lequel le boîtier inférieur (100 ; 1100) comprend des nervures de guidage (170 ; 1170) pour placer la carte de commande à une position espacée d'une hauteur prédéterminée de la surface supérieure du boîtier inférieur (100 ; 1100), et pour empêcher toute secousse de la carte de commande.

31. Dispositif de télésurveillance (1 ; 10) selon la revendication 29, dans lequel la nervure de guidage (170 ; 1170) est sensiblement en forme de « L ».

32. Dispositif de télésurveillance (1 ; 10) selon la revendication 1, dans lequel le boîtier supérieur (400 ; 1400) comprend au moins un bossage de support supérieur faisant saillie de celui-ci pour supporter la carte de commande.

33. Dispositif de télésurveillance (1 ; 10) selon la revendication 1, dans lequel le boîtier inférieur (100 ; 1100) comprend au moins un bossage de support inférieur (181 ; 1181) faisant saillie de celui-ci pour supporter la carte de commande.

34. Dispositif de télésurveillance (1 ; 10) selon la revendication 1, comprenant en outre des moyens d'attachement pour attacher le boîtier à une paroi à un endroit éloigné de l'appareil domestique.

35. Dispositif de télésurveillance (1 ; 10) selon la revendication 34, dans lequel les moyens d'attachement comprennent :
une portion de montage (190 ; 1190) faisant saillie vers l'extérieur depuis un fond du boîtier inférieur (100 ; 1100) qui est un côté exposé du boîtier inférieur (100 ; 1100), et
une suspente (900 ; 1900) à attacher fixement à la paroi éloignée de l'appareil domestique pour placer la portion de montage sur celle-ci.

36. Dispositif de télésurveillance (1 ; 10) selon la revendication 35, dans lequel l'une de la portion de montage (190 ; 1190) et de la suspente (900 ; 1900) comprend des saillies de guidage (191 ; 1191), et l'autre comprend une portion d'assise (910 ; 1910) comportant des rainures de guidage pour placer, de manière à pouvoir coulisser, les saillies de guidage respectivement à l'intérieur de celles-ci.

37. Dispositif de télésurveillance (1 ; 10) selon la revendication 35, dans lequel la suspente (900 ; 1900) présente une taille inférieure à celle du boîtier inférieur (100 ; 1100).

38. Dispositif de télésurveillance (1 ; 10) selon la revendication 1, comprenant en outre un haut-parleur pour annoncer un état de déroulement de l'appareil domestique avec un son désigné.

39. Dispositif de télésurveillance (1 ; 10) selon la revendication 1, dans lequel le boîtier comprend en outre :
un boîtier extérieur (500) monté, de manière détachable, sur un côté supérieur du boîtier supérieur, le boîtier extérieur comportant une fenêtre d'affichage (510) correspondant à la fenêtre.

40. Dispositif de télésurveillance (1 ; 10) selon la revendication 39, comprenant en outre une feuille transparente sur une face supérieure du boîtier extérieur (500), qui est une surface exposée, pour voir un intérieur à travers la fenêtre d'affichage, et une feuille protectrice sur une surface supérieure de la feuille transparente comportant une fenêtre transparente correspondant à la fenêtre d'affichage sur le boîtier extérieur.

41. Dispositif de télésurveillance (1 ; 10) selon la revendication 40, dans lequel la feuille transparente et la feuille protectrice (700 ; 1700) présentent des tailles correspondant respectivement à la surface supérieure du boîtier supérieur (400 ; 1400).

42. Dispositif de télésurveillance (1 ; 10) selon la revendication 40, dans lequel la feuille transparente est prévue pour être placée sur la surface supérieure du boîtier extérieur (500), avec une taille correspondant à une taille de la fenêtre d'affichage sur le boîtier extérieur, et la feuille protectrice (700 ; 1700) présente une taille correspondant à la surface supérieure du boîtier extérieur.

43. Dispositif de télésurveillance (1 ; 10) selon la revendication 40, dans lequel la feuille transparente est constituée de polyéthylène téréphtalate (PET).

44. Dispositif de télésurveillance (1 ; 10) selon la revendication 40, dans lequel la feuille protectrice (700 ; 1700) est constituée d'un métal léger, comme de l'aluminium.

45. Dispositif de télésurveillance (1 ; 10) selon la revendication 40, dans lequel le boîtier extérieur (500) comprend une rainure anti-interférence (502) dans la surface supérieure du boîtier extérieur pour empêcher toute interférence de bavures laissées à un bord de la feuille protectrice (700 ; 1700).
